# EUROPEAN PATENT APPLICATION

(11) **EP 4 773 170 A1**
(43) Date of publication of application: **08.07.2026**
(21) Application number: 24859519.1
(22) Date of filing: 19.08.2024
(51) Int. Cl.: H01L 21/304

(54) **SUBSTRATE PROCESSING METHOD**

(30) Priority: 29.08.2023 JP 2023138688
(71) Applicant: SCREEN Holdings Co., Ltd., Kyoto-shi, Kyoto 602-8585 (JP)
(72) Inventor: TAKEMATSU Yusuke, Kyoto-shi, Kyoto 602-8585 (JP); KATO Masahiko, Kyoto-shi, Kyoto 602-8585 (JP); ISHIZU Takaaki, Kyoto-shi, Kyoto 602-8585 (JP); SHIRAO Takashi, Kyoto-shi, Kyoto 602-8585 (JP)
(74) Representative: Kilian Kilian & Partner mbB
(86) International application number: PCT/JP2024/029314
(87) International publication number: WO 2025/047486

(57) **Abstract**

Provided is a technology that can effectively reduce a pattern collapse ratio of a substrate. A method of processing a substrate includes a holding step, a liquid supplying step, a first drying liquid supplying step, a second drying liquid supplying step, and a drying step. In the first drying liquid supplying step, a first drying liquid having a first boiling point (bp1) and a surface tension lower than that of the processing liquid is supplied to a first main surface of the substrate. In the second drying liquid supplying step, a second drying liquid having a second boiling point (bp2) and a surface tension lower than that of the first drying liquid is supplied to the first main surface of the substrate. In the drying step, the substrate is dried. A second main surface of the substrate is heated to a first temperature in at least a part of a time in the first drying liquid supplying step, and at least a part of the second main surface of the substrate is heated to a second temperature, in at least a part of a time in the second drying liquid supplying step. A positive or negative sign of a value obtained by subtracting the second temperature from the first temperature is identical to a positive or negative sign of a value obtained by subtracting the second boiling point (bp2) from the first boiling point (bp1).

## Description

### TECHNICAL FIELD

The present disclosure relates to a method of processing a substrate.

### BACKGROUND ART

Single-wafer substrate processing apparatuses each processing a substrate have conventionally been disclosed (for example, Patent Document 1). In Patent Document 1, a substrate processing apparatus supplies a substrate with a rinse liquid, then supplies the substrate with isopropyl alcohol having a surface tension lower than that of the rinse liquid, and then dries the substrate. This suppresses pattern collapse on the substrate in the drying.

### PRIOR ART DOCUMENT

### PATENT DOCUMENT

Patent Document 1: Japanese Patent Application Laid-Open No. 2015-23182

### SUMMARY

### PROBLEM TO BE SOLVED BY THE INVENTION

Under the technology described in Patent Document 1, however, the substrate is dried by evaporating isopropyl alcohol. Recent years have seen tendencies of pattern collapse on substrates as patterns have been miniaturized. Thus, simply evaporating isopropyl alcohol faces difficulty in sufficiently reducing a pattern collapse ratio.

Thus, the present disclosure has an object of providing a technology that can effectively reduce a pattern collapse ratio of a substrate.

### MEANS TO SOLVE THE PROBLEM

A first aspect is a method of processing a substrate, the method including: a holding step of holding a substrate having a first main surface on which a pattern is formed, and a second main surface opposite to the first main surface; a liquid supplying step of supplying a processing liquid to the first main surface of the substrate; a first drying liquid supplying step of supplying, after the liquid supplying step, a first drying liquid to the first main surface of the substrate, the first drying liquid having a first boiling point and having a surface tension lower than a surface tension of the processing liquid; a second drying liquid supplying step of supplying, after the first drying liquid supplying step, a second drying liquid to the first main surface of the substrate, the second drying liquid having a second boiling point different from the first boiling point, and having a surface tension lower than the surface tension of the first drying liquid; and a drying step of drying the substrate after the second drying liquid supplying step, wherein the second main surface of the substrate is heated to a first temperature in at least a part of a time in the first drying liquid supplying step, at least a part of the second main surface of the substrate is heated to a second temperature different from the first temperature, in at least a part of a time in the second drying liquid supplying step, and a positive or negative sign of a value obtained by subtracting the second temperature from the first temperature is identical to a positive or negative sign of a value obtained by subtracting the second boiling point from the first boiling point.

A second aspect is the method according to the first aspect, wherein a heating medium of a first medium temperature is supplied to the second main surface of the substrate in the first drying liquid supplying step, the heating medium of a second medium temperature is supplied to the second main surface of the substrate in the second drying liquid supplying step, and a positive or negative sign of a value obtained by subtracting the second medium temperature from the first medium temperature is identical to a positive or negative sign of a value obtained by subtracting the second boiling point from the first boiling point.

A third aspect is the method according to the first or second aspect, wherein a higher one of the first temperature and the second temperature is higher than or equal to a lower one of the first boiling point and the second boiling point.

A fourth aspect is the method according to any one of the first to third aspects, wherein miscibility between the processing liquid and the first drying liquid is higher than miscibility between the processing liquid and the second drying liquid.

A fifth aspect is the method according to any one of the first to fourth aspects, wherein in the first drying liquid supplying step, the first drying liquid is supplied to the first main surface of the substrate at a flow rate at which a temperature of the first main surface of the substrate becomes lower than the first boiling point of the first drying liquid, while the at least the part of the second main surface of the substrate is heated to the first boiling point of the first drying liquid or higher.

A sixth aspect is the method according to any one of the first to fifth aspects, wherein in the second drying liquid supplying step, the second drying liquid is supplied to the first main surface of the substrate at a flow rate at which a temperature of the first main surface of the substrate becomes lower than the second boiling point of the second drying liquid, while the at least the part of the second main surface of the substrate is heated to the second boiling point of the second drying liquid or higher.

A seventh aspect is the method according to any one of the first to sixth aspects, wherein the second temperature is higher than the first temperature, and in the second drying liquid supplying step, a temperature of the second main surface of the substrate is lower than the second temperature in a former period of a second drying liquid supply time during which the second drying liquid is supplied, and the second main surface of the substrate is heated to the second temperature in a latter period of the second drying liquid supply time.

### EFFECTS OF THE INVENTION

According to the first aspect, when the second boiling point is higher than the first boiling point, the second temperature is higher than the first temperature. Thus, the temperature of the second drying liquid on the first main surface of the substrate can be further increased in the second drying liquid supplying step. Therefore, the first drying liquid can be replaced with the second drying liquid on the first main surface of the substrate with higher replacement efficiency. Consequently, the residual volume of the first drying liquid with a higher surface tension can be reduced at the end of the second drying liquid supplying step. This can reduce a pattern collapse ratio in the drying. Since the temperature of the second drying liquid is high at the end of the second drying liquid supplying step, the second drying liquid can be evaporated at a lower surface tension and at a higher evaporation rate. This can also reduce the pattern collapse ratio.

When the first boiling point is higher than the second boiling point, the first temperature is higher than the second temperature. Thus, the temperature of the first drying liquid on the first main surface of the substrate can be further increased in the first drying liquid supplying step. Therefore, the processing liquid can be replaced with the first drying liquid on the first main surface of the substrate with higher replacement efficiency. Consequently, the residual volume of the processing liquid with a higher surface tension can be reduced at the end of the first drying liquid supplying step. This can reduce the pattern collapse ratio in the drying.

According to the second aspect, the second main surface of the substrate can be heated with a simple structure to each of the first temperature corresponding to the first boiling point of the first drying liquid and the second temperature corresponding to the second boiling point of the second drying liquid.

According to the third aspect, when the second boiling point is higher than the first boiling point, the second main surface of the substrate is heated to the second temperature higher than the first boiling point of the first drying liquid in at least a part of the time of the second drying liquid supplying step. Thus, the temperature of the second drying liquid on the first main surface of the substrate can be further increased. Therefore, the first drying liquid can be replaced with the second drying liquid with higher replacement efficiency.

The fourth aspect allows, with higher replacement efficiency, the processing liquid to be replaced with the first drying liquid, and the first drying liquid to be replaced with the second drying liquid.

According to the fifth aspect, in the first drying liquid supplying step, the first drying liquid is supplied at a flow rate at which a temperature of the first main surface of the substrate becomes lower than the first boiling point, while the second main surface of the substrate is heated to the first boiling point of the first drying liquid or higher. Thus, a boil of the first drying liquid can be more reliably suppressed while the temperature of the first main surface of the substrate is brought closer to the first boiling point of the first drying liquid, and adherence of particles can be suppressed.

According to the sixth aspect, in the second drying liquid supplying step, the second drying liquid is supplied at a flow rate at which a temperature of the first main surface of the substrate becomes lower than the second boiling point, while the second main surface of the substrate is heated to the second boiling point of the second drying liquid or higher. Thus, a boil of the second drying liquid can be more reliably suppressed while the temperature of the first main surface of the substrate is brought closer to the second boiling point of the second drying liquid, and adherence of particles can be suppressed. Since the temperature of the first main surface is closer to the second boiling point, a drying liquid can be evaporated at a lower surface tension and in a shorter period in the next drying step. This can effectively reduce the pattern collapse ratio.

According to the seventh aspect, the power consumption can be reduced.

### BRIEF DESCRIPTION OF DRAWINGS

[FIG. 1] is a plan view schematically illustrating an example structure of a substrate processing apparatus.
[FIG. 2] is a block diagram schematically illustrating an example internal configuration of a controller.
[FIG. 3] is a vertical cross-sectional view schematically illustrating an example structure of a processing unit according to Embodiment 1.
[FIG. 4] is a flowchart illustrating example operations of the processing unit.
[FIG. 5] is a diagram schematically illustrating an example state of the processing unit in a first drying liquid supplying step.
[FIG. 6] is a diagram schematically illustrating an example state of the processing unit in a second drying liquid supplying step.
[FIG. 7] is a diagram schematically illustrating a first example of a timing chart of the processing unit according to Embodiment 1, time variations in medium temperature of a heating medium, and time variations in temperature of a second main surface of a substrate.
[FIG. 8] is a diagram schematically illustrating a second example of the timing chart of the processing unit according to Embodiment 1, time variations in medium temperature of the heating medium, and time variations in temperature of the second main surface of the substrate.
[FIG. 9] is a diagram schematically illustrating a first example of a timing chart of a processing unit according to Embodiment 2, time variations in medium temperature of the heating medium, time variations in temperature of the second main surface of the substrate, and time variations in temperature of a first main surface of the substrate.
[FIG. 10] is a diagram schematically illustrating a second example of a timing chart of the processing unit according to Embodiment 2, time variations in medium temperature of the heating medium, time variations in temperature of the second main surface of the substrate, and time variations in temperature of the first main surface of the substrate.
[FIG. 11] is a diagram schematically illustrating an example of a timing chart of a processing unit according to Embodiment 3, time variations in medium temperature of the heating medium, and time variations in the temperature of the second main surface of the substrate.
[FIG. 12] is a flowchart illustrating first example operations of a processing unit according to Embodiment 4.
[FIG. 13] is a flowchart illustrating second example operations of the processing unit according to Embodiment 4.
[FIG. 14] is a diagram schematically illustrating an example structure of a processing unit according to Embodiment 5.

### DESCRIPTION OF EMBODIMENTS

Embodiments will be described in detail below with reference to drawings. It should be noted that dimensions and the number of parts are shown in exaggeration or in simplified form as appropriate for the sake of easier understanding. The same reference signs are assigned to parts having similar structures and functions, and overlapping description will be omitted in the following description.

In the following description, the same reference signs are assigned to the same constituent elements, and their names and functions are the same. Therefore, detailed description of such constituent elements may be omitted to avoid redundant description.

Even when the ordinal numbers such as "first" and "second" are used in the following description, these terms are used for convenience to facilitate the understanding of the details of Embodiments. The order indicated by these ordinal numbers does not restrict the details of Embodiments.

Unless otherwise noted, the expressions indicating relative or absolute positional relationships (e.g., "in one direction", "along one direction", "parallel", "orthogonal", "central", "concentric", and "coaxial") include those exactly indicating the positional relationships and those where an angle or a distance is relatively changed within tolerance or to the extent that similar functions can be obtained. Unless otherwise noted, the expressions indicating equality (e.g., "same", "equal", and "homogeneous") include those indicating quantitatively exact equality and those in the presence of a difference within tolerance or to the extent that similar functions can be obtained. Unless otherwise noted, the expressions indicating shapes (e.g., "rectangular" or "cylindrical") include those indicating geometrically exact shapes and those indicating, for example, roughness or a chamfer to the extent that similar advantages can be obtained. An expression "comprising", "including", "containing", or "having" one constituent element is not an exclusive expression for excluding the presence of the other constituent elements. An expression "at least one of A, B, and C" involves "only A", "only B", "only C", "any two of A, B, and C", and "all of A, B, and C".

### <Embodiment 1>

### <Overall structure of substrate processing apparatus>

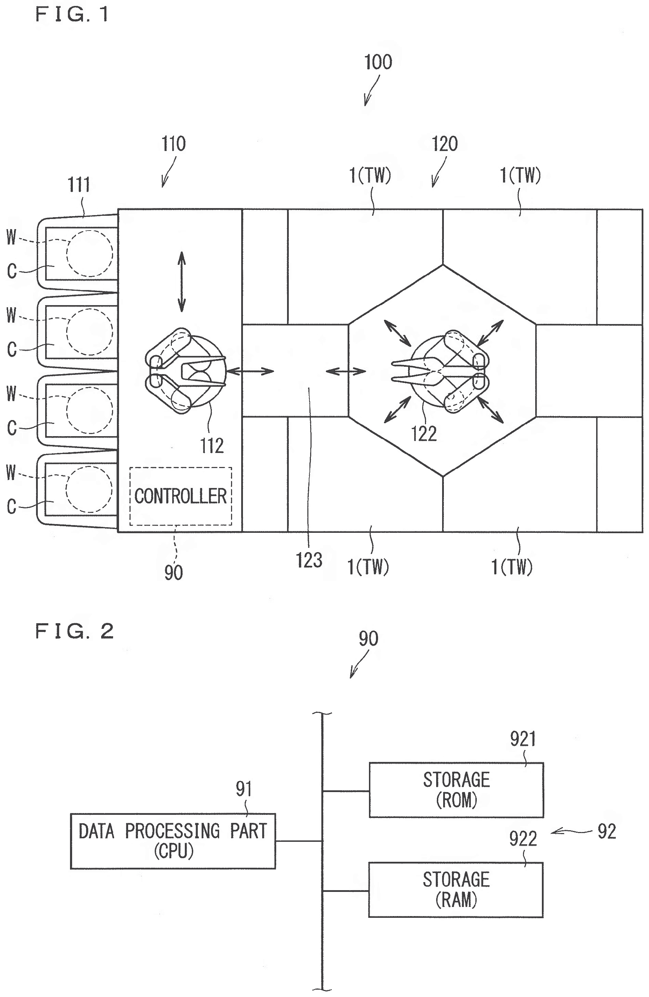

FIG. 1 is a plan view schematically illustrating an example structure of a substrate processing apparatus 100. The substrate processing apparatus 100 is a single-wafer processing apparatus that processes substrates W one by one.

Examples of the substrates W include a semiconductor wafer, a liquid crystal display substrate, an organic electroluminescence (EL) substrate, a flat panel display (FPD) substrate, an optical display substrate, a magnetic disk substrate, an optical disk substrate, a magneto-optical disk substrate, a photomask substrate, and a solar cell substrate. The substrates W have a thin plate shape with a first main surface Wa and a second main surface Wb. The second main surface Wb is a surface opposite to the first main surface Wa. In the following, the substrates W are semiconductor wafers. The substrates W are, for example, disk-shaped. Each of the substrates W has a diameter of, for example, approximately 300 mm, and has a thickness of, for example, approximately more than or equal to 0.5 mm and less than or equal to 3 mm. A pattern is formed on the main surface of the substrate W. Examples of the pattern herein include at least one of a wiring pattern, an electrode pattern, a semiconductor pattern, and an insulation pattern. An aspect ratio in the pattern is, for example, 5 or higher and 500 or lower. A pattern width is, for example, 3 nm or higher and 50 nm or lower. A pattern with such a high aspect ratio tends to collapse.

In the example of FIG. 1, the substrate processing apparatus 100 includes an indexer block 110, a processing block 120, and a controller 90. The processing block 120 is a part that mainly processes the substrates W, and the indexer block 110 is a part that mainly transports the substrates W between an exterior of the substrate processing apparatus 100 and the processing block 120.

The indexer block 110 includes load ports 111 and a first transporter 112. A substrate container (hereinafter referred to as a "carrier") C loaded from an exterior is placed on each of the load ports 111. A plurality of the substrates W are housed in the carrier C while being aligned at intervals, for example, in a vertical direction. In the example of FIG. 1, a plurality of the load ports 111 are aligned.

The first transporter 112 is a transport robot, and can take unprocessed substrates W from the carrier C placed on each of the load ports 111. The first transporter 112 can be referred to as an indexer robot. The first transporter 112 transports, to the processing block 120, the unprocessed substrates W which have been taken from the carrier C. The processing block 120 can process the unprocessed substrates W. Furthermore, the first transporter 112 can receive the processed substrates W from the processing block 120, and transport the processed substrates W to the carriers C of the load ports 111.

In the example of FIG. 1, the processing block 120 includes one or more processing units 1 and a second transporter 122. The second transporter 122 is a transport robot, and can transport the substrates W between the first transporter 112 and each of the processing units 1. In the example of FIG. 1, the processing block 120 also includes a placement part 123. The placement part 123 is, for example, a shelf on which the substrates W aligned in the vertical direction can be placed. The first transporter 112 places the unprocessed substrates W on the placement part 123. The second transporter 122 takes the unprocessed substrates W from the placement part 123, and transports the substrates W to the processing units 1. Each of the processing units 1 processes the substrates W. A structure of each of the processing units 1 will be described later. The second transporter 122 takes the processed substrates W from the processing units 1, and transports the substrates W to the placement part 123. The first transporter 112 takes the substrates W from the placement part 123, and transports the substrates W to the carriers C of the load ports 111.

In the example of FIG. 1, the plurality of (e.g., four) processing units 1 are disposed to surround the second transporter 122 in a plan view. This second transporter 122 can be referred to as a center robot. The plurality of processing units 1 at the respective positions in a plan view may be stacked in the vertical direction. In other words, a plurality of (e.g., four) towers TW each including the plurality of processing units 1 stacked in the vertical direction may be disposed to surround the second transporter 122.

The controller 90 has centralized control over the substrate processing apparatus 100. Specifically, the controller 90 controls the first transporter 112, the second transporter 122, and the processing units 1. FIG. 2 is a block diagram schematically illustrating an example internal configuration of the controller 90. The controller 90 is an electronic circuit, and includes, for example, a data processing part 91 and a storage 92. In a specific example of FIG. 2, the data processing part 91 and the storage 92 are mutually connected through a bus 93. The data processing part 91 may be, for example, an arithmetic processing unit such as a central processing unit (CPU). The storage 92 may include a non-transitory storage (e.g., a read-only memory (ROM)) 921 and a transitory storage (e.g., a random-access memory (RAM)) 922. The non-transitory storage 921 may store, for example, a program for defining processes to be executed by the controller 90. The data processing part 91 executes this program, so that the controller 90 can execute the processes defined in the program. Obviously, hardware such as a dedicated logic circuit may execute a part or all the processes to be executed by the controller 90.

### <Outline of processing unit>

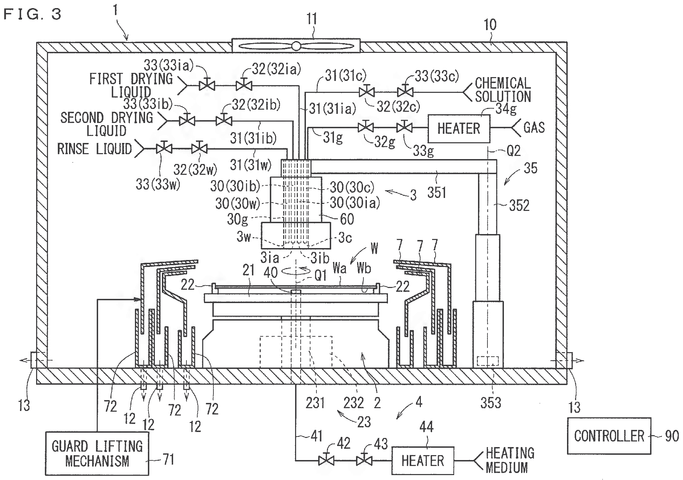

FIG. 3 is a vertical cross-sectional view schematically illustrating an example structure of the processing unit 1 according to Embodiment 1. All the processing units 1 belonging to the substrate processing apparatus 100 need not have the structure exemplified in FIG. 3. At least one of the processing units 1 of the substrate processing apparatus 100 should have the structure exemplified in FIG. 3.

The processing unit 1 includes a substrate holder 2, a dispenser 3, and a substrate heating part 4.

In the example of FIG. 3, a chamber 10 is disposed in the processing unit 1. The chamber 10 is box-shaped, and its internal space corresponds to a processing space in which the substrate W is processed. The chamber 10 includes an openable and closeable loading/unloading entrance (not illustrated). The second transporter 122 loads the unprocessed substrate W into the chamber 10 through the loading/unloading entrance, and unloads the processed substrate W from the chamber 10 through the loading/unloading entrance.

In the example of FIG. 3, a fan filter unit 11 is disposed in a ceiling of the chamber 10. The fan filter unit 11 draws in the air outside the chamber 10 and cleans the air, and supplies the cleaned air to an interior of the chamber 10. The operation of the fan filter unit 11 forms a downflow of the cleaned air in the chamber 10. In the example of FIG. 3, an upstream end of an emission pipe 13 is connected to a lower portion of a sidewall of the chamber 10. Gas in the chamber 10 is discharged to an exterior through the emission pipe 13.

The substrate holder 2 is disposed within the chamber 10, and rotates the substrate W about a rotation axis line Q1 while holding the substrate W in a horizontal attitude. The horizontal attitude herein is an attitude in which the thickness direction of the substrate W is along the vertical direction. The rotation axis line Q1 is an axis that passes through the center of the substrate W and is along the vertical direction. This substrate holder 2 can be referred to as a spin chuck.

Here, the first main surface Wa of the substrate W on which the pattern is formed faces vertically upward. In other words, the first main surface Wa of the substrate W held by the substrate holder 2 corresponds to an upper surface in the example of FIG. 3. Examples of the pattern include at least one of a wiring pattern, an insulation pattern, and a semiconductor pattern.

In the example of FIG. 3, the substrate holder 2 includes a spin base 21, chuck pins 22, and a rotation driver 23. The spin base 21 is plate-shaped (e.g., disk-shaped), and is disposed in an attitude such that its thickness direction is along the vertical direction. A plurality of the chuck pins 22 are arranged on an upper surface of the spin base 21. The plurality of chuck pins 22 are arranged, for example, at equal intervals along a circumferential direction of the rotation axis line Q1. Each of the chuck pins 22 is displaceable between a holding position and a releasing position to be described next. The holding position is a position at which the chuck pin 22 abuts the peripheral edge of the substrate W. The plurality of chuck pins 22 hold the substrate W by being stopped at the respective holding positions. FIG. 3 illustrates the chuck pins 22 stopped at the holding positions. The releasing position is a position at which each of the chuck pins 22 is away from the substrate W. A hold of the substrate W by the chuck pins 22 is released by stopping the chuck pins 22 at the respective releasing positions. The substrate holder 2 includes a pin driver (not illustrated) that displaces the chuck pins 22. The pin driver includes a driving source, for example, a motor or an air cylinder, and is controlled by the controller 90.

The rotation driver 23 includes a shaft 231 and a motor 232. An upper end of the shaft 231 is connected to a lower surface of the spin base 21. The shaft 231 extends along the rotation axis line Q1 from the lower surface of the spin base 21. The motor 232 is controlled by the controller 90, and rotates the shaft 231 about the rotation axis line Q1. Consequently, the spin base 21, the chuck pins 22, and the substrate W rotate in unison about the rotation axis line Q1.

The substrate holder 2 need not always include the chuck pins 22. The substrate holder 2 may hold the substrate W, for example, in a chuck method such as a vacuum chuck method, an electrostatic chuck method, or a Bernoulli chuck method.

The dispenser 3 dispenses a processing liquid toward the first main surface Wa of the substrate W held by the substrate holder 2. As illustrated in FIG. 3, the dispenser 3 includes at least one nozzle 30. The nozzle 30 dispenses the processing liquid toward the first main surface Wa of the substrate W held by the substrate holder 2. Since the first main surface Wa corresponds to the upper surface of the substrate W, the nozzle 30 is disposed vertically above the substrate W held by the substrate holder 2. The nozzle 30 is, for example, a straight nozzle that dispenses the processing liquid in the form of a continuous stream.

In the example of FIG. 3, a nozzle 30c, a nozzle 30w, a nozzle 30ia, and a nozzle 30ib are indicated as the nozzles 30. In the example of FIG. 3, the nozzle 30c, the nozzle 30w, the nozzle 30ia, and the nozzle 30ib extend along the vertical direction. In the example of FIG. 3, an outlet 3c is formed at a lower surface of the nozzle 30c, an outlet 3w is formed at a lower surface of the nozzle 30w, an outlet 3ia is formed at a lower surface of the nozzle 30ia, and an outlet 3ib is formed at a lower surface of the nozzle 30ib. The nozzle 30c dispenses a chemical solution from the outlet 3c. The nozzle 30w dispenses a rinse liquid from the outlet 3w. The nozzle 30ia dispenses a first drying liquid from the outlet 3ia. The nozzle 30ib dispenses a second drying liquid from the outlet 3ib. The chemical solution, the rinse liquid, the first drying liquid, and the second drying liquid are example processing liquids, and specific examples of these will be described later.

Each of the nozzle 30c, the nozzle 30w, the nozzle 30ia, and the nozzle 30ib dispenses a processing liquid toward the center of the first main surface Wa of the substrate W held by the substrate holder 2. In the example of FIG. 3, the nozzle 30c, the nozzle 30w, the nozzle 30ia, and the nozzle 30ib are adjacent to each other in a horizontal direction, and are fixed to each other. In the example of FIG. 3, the nozzle 30c, the nozzle 30w, the nozzle 30ia, and the nozzle 30ib are disposed inside a facing part 60. The facing part 60 is, for example, of a cylindrical shape. The facing part 60 has a hollow shape. A lower port of the hollow part is opened at the lower surface of the facing part 60. The nozzle 30c, the nozzle 30w, the nozzle 30ia, and the nozzle 30ib are disposed in the hollow part of the facing part 60, and the processing liquid dispensed from each of the nozzles 30 flows from the lower port of the facing part 60. In the example of FIG. 3, the facing part 60 is disposed at a position facing the center of the substrate W held by the substrate holder 2 in the vertical direction.

The nozzles 30 are connected to downstream ends of supply pipes 31, and upstream ends of the supply pipes 31 are connected to processing liquid supply sources. In the example of FIG. 3, a supply pipe 31c, a supply pipe 31w, a supply pipe 31ia, and a supply pipe 31ib are indicated as the supply pipes 31.

The downstream end of the supply pipe 31c is connected to the nozzle 30c, and the upstream end of the supply pipe 31c is connected to a chemical solution supply source. The chemical solution supply source includes a tank (not illustrated) that stores a chemical solution, and supplies the chemical solution to the upstream end of the supply pipe 31c. For example, liquids such as hydrofluoric-nitric acid obtained by mixing hydrofluoric acid, nitric acid, and water, hydrofluoric acid-hydrogen peroxide mixture (FPM) obtained by mixing hydrofluoric acid, hydrogen peroxide, and water, tetramethylammonium hydroxide (TMAH), a mixture of sulfuric acid and hydrogen peroxide solution (SPM), ammonia water, a mixture (SC-1) of ammonia, hydrogen peroxide, and water, and a mixture (SC-2) of hydrochloric acid, hydrogen peroxide, and water are applicable as the chemical solutions. Each of the chemical solutions need not be a mixture but may be a single liquid. For example, single liquids such as hydrofluoric acid (HF), aqueous hydrogen peroxide, and sulfuric acid are applicable as chemical solutions.

The downstream end of the supply pipe 31w is connected to the nozzle 30w, and the upstream end of the supply pipe 31w is connected to a rinse liquid supply source. The rinse liquid supply source includes a tank (not illustrated) that stores a rinse liquid, and supplies the rinse liquid to the upstream end of the supply pipe 31w. For example, pure water, carbon dioxide water, or ozonized water is applicable as the rinse liquid.

A downstream end of the supply pipe 31ia is connected to the nozzle 30ia, and the upstream end of the supply pipe 31ia is connected to a first drying liquid supply source. The first drying liquid supply source includes a tank (not illustrated) that stores the first drying liquid, and supplies the drying liquid to the upstream end of the supply pipe 31ia. A downstream end of the supply pipe 31ib is connected to the nozzle 30ib, and the upstream end of the supply pipe 31ib is connected to a second drying liquid supply source. The second drying liquid supply source includes a tank (not illustrated) that stores the second drying liquid, and supplies the drying liquid to the upstream end of the supply pipe 31ib. A surface tension of the second drying liquid is lower than that of the first drying liquid. The miscibility between the first drying liquid and the rinse liquid is higher than that between the second drying liquid and the rinse liquid. The miscibility between the first drying liquid and the second drying liquid is higher than, for example, that between the second drying liquid and the rinse liquid. Specifically, for example, an organic solvent such as isopropyl alcohol is applicable as the first drying liquid. For example, a fluorinated organic solvent (an organo-fluorine compound) such as hydrofluoroolefin is applicable as the second drying liquid.

A first boiling point of the first drying liquid differs from a second boiling point of the second drying liquid. The first boiling point of the first drying liquid may be lower or higher than the second boiling point of the second drying liquid. When the first drying liquid is isopropyl alcohol, the first boiling point of the first drying liquid is 82.4 degrees centigrade. When the second drying liquid is Opteon (registered trademark) SF70 (methoxyperfluoroheptene), the second boiling point of the second drying liquid is 110.5 degrees centigrade. In this case, the first boiling point of the first drying liquid is lower than the second boiling point of the second drying liquid. Furthermore, when the second drying liquid is Opteon (registered trademark) SF10 (fluoroheptene), the second boiling point of the second drying liquid is 71.5 degrees centigrade. In this case, the first boiling point of the first drying liquid is higher than the second boiling point of the second drying liquid.

A supply valve 32 and a flow rate regulation valve 33 are inserted into each of the supply pipes 31. In the example of FIG. 3, a supply valve 32c and a flow rate regulation valve 33c are inserted into the supply pipe 31c, a supply valve 32w and a flow rate regulation valve 33w are inserted into the supply pipe 31w, a supply valve 32ia and a flow rate regulation valve 33ia are inserted into the supply pipe 31ia, and a supply valve 32ib and a flow rate regulation valve 33ib are inserted into the supply pipe 31ib. The supply valve 32 switches between opening and closing of the supply pipe 31. The flow rate regulation valve 33 regulates a flow rate of a processing liquid flowing through the supply pipe 31. The flow rate regulation valve 33 may be a massflow controller. The supply valve 32 and the flow rate regulation valve 33 are controlled by the controller 90.

The dispenser 3 dispenses various processing liquids toward the first main surface Wa of the substrate W in an order to be described later. Consequently, the processing unit 1 can sequentially perform various operations corresponding to the types of the processing liquids on the first main surface Wa of the substrate W. Specific processes will be described later.

In the example of FIG. 3, the facing part 60 is configured to dispense gas toward the first main surface Wa of the substrate W held by the substrate holder 2. In the example of FIG. 3, space except the nozzle 30 in the hollow part of the facing part 60 functions as a gas passage 30g. The lower port at the lower surface of the facing part 60 corresponds to an outlet of the gas passage 30g.

In the example of FIG. 3, an upper portion of the facing part 60 is connected to a downstream end of a supply pipe 31g. In other words, the downstream end of the supply pipe 31g is connected to the gas passage 30g. An upstream end of the supply pipe 31g is connected to a gas supply source. The gas supply source includes a reservoir (not illustrated) that stores an inert gas, and supplies the inert gas to the upstream end of the supply pipe 31g. Examples of the inert gas include at least one of nitrogen gas and noble gas. Examples of the noble gas include an argon gas.

A supply valve 32g, a flow rate regulation valve 33g, and a heater 34g are disposed in the supply pipe 31g. The supply valve 32g switches between opening and closing of the supply pipe 31g. The flow rate regulation valve 33g regulates a flow rate of the inert gas flowing through the supply pipe 31g. The heater 34g heats the inert gas flowing through the supply pipe 31g. The heater 34g may be, for example, an electric resistance heater with an electric heating wire. The supply valve 32g, the flow rate regulation valve 33g, and the heater 34g are controlled by the controller 90.

When the supply valve 32g is opened and the heater 34g operates, the inert gas at a high temperature is dispensed from the center of the lower surface of the facing part 60 (i.e., the lower port of the gas passage 30g) toward the center of the first main surface Wa of the substrate W. This can promote drying of the substrate W.

In the example of FIG. 3, a movement driver 35 is disposed in the processing unit 1. The movement driver 35 moves a dispensing head including the nozzle 30c, the nozzle 30w, the nozzle 30ia, the nozzle 30ib, and the facing part 60 in unison. Specifically, the movement driver 35 moves the dispensing head between a processing position and a waiting position to be described next. The processing position is a position at which each of the nozzle 30c, the nozzle 30w, the nozzle 30ia, and the nozzle 30ib dispenses a processing liquid toward the first main surface Wa of the substrate W, for example, a position facing the center of the first main surface Wa of the substrate W in the vertical direction. The processing position is also a position at which the facing part 60 dispenses the inert gas toward the first main surface Wa of the substrate W. In the example of FIG. 3, the dispensing head stopped at the processing position is illustrated. The waiting position is a position at which each of the nozzle 30c, the nozzle 30w, the nozzle 30ia, and the nozzle 30ib does not dispense a processing liquid toward the first main surface Wa of the substrate W, for example, a position outside the substrate holder 2 in the radial direction. The waiting position is also a position at which the facing part 60 does not dispense the inert gas toward the first main surface Wa of the substrate W.

FIG. 3 illustrates an example specific structure of the movement driver 35. In the example of FIG. 3, the movement driver 35 includes an arm 351, a support pillar 352, and a driving source 353. The support pillar 352 is disposed outside guards 7 to be described later in the radial direction, and extends in the vertical direction. The arm 351 extends in the horizontal direction, its tip is connected to the dispensing head, and its base end is connected to the support pillar 352. The driving source 353 is controlled by the controller 90, and rotates the support pillar 352 about a central axis line Q2 in forward and reverse directions in a predetermined angle range. The driving source 353 includes, for example, a motor. When the support pillar 352 is rotated about the central axis line Q2 in the forward and reverse directions in the predetermined angle range, the dispensing head reciprocates in a circumferential direction of the central axis line Q2. The support pillar 352 is set such that the processing position and the waiting position are located along a movement trajectory of the dispensing head. The movement driver 35 is not always limited to the structure in FIG. 3 but may include, for example, a direct-acting mechanism such as a linear motor.

The substrate heating part 4 heats the second main surface Wb of the substrate W held by the substrate holder 2. In the example of FIG. 3, the substrate heating part 4 is disposed at a position facing the second main surface Wb of the substrate W in the vertical direction. Since the second main surface Wb of the substrate W corresponds to a lower surface in the example of FIG. 3, the substrate heating part 4 is disposed immediately below the substrate W.

In the example of FIG. 3, the substrate heating part 4 includes a nozzle 40. The nozzle 40 dispenses a heating medium toward the second main surface Wb of the substrate W. Since the second main surface Wb of the substrate W corresponds to the lower surface in the example of FIG. 3, the nozzle 40 can be referred to as a lower-surface nozzle. In the example of FIG. 3, a through hole is formed in the center of the spin base 21 of the substrate holder 2, and the shaft 231 is a hollow shaft. The through hole of the spin base 21 is connected to the hollow part of the shaft 231 in the vertical direction. A part of the nozzle 40 is disposed in the through hole. An outlet is formed at the upper surface of the nozzle 40. The outlet of the nozzle 40 faces the center of the second main surface Wb of the substrate W in the vertical direction. The nozzle 40 dispenses the heating medium toward the center of the second main surface Wb of the substrate W.

A downstream end of a supply pipe 41 is connected to the nozzle 40. The supply pipe 41 extends inside the shaft 231, and penetrates the shaft 231. An upstream end of the supply pipe 41 is connected to a heating medium supply source. The heating medium is fluid (gas or liquid), and is liquid such as water as a specific example. The heating medium supply source includes a tank (not illustrated) that stores the heating medium, and supplies the heating medium to the upstream end of the supply pipe 41.

In the example of FIG. 3, a supply valve 42, a flow rate regulation valve 43, and a heater 44 are disposed in the supply pipe 41. The supply valve 42 switches between opening and closing of the supply pipe 41. The flow rate regulation valve 43 regulates a flow rate of the heating medium flowing through the supply pipe 41. The flow rate regulation valve 43 may be a massflow controller. The heater 44 heats the heating medium flowing through the supply pipe 41. The heater 44 may be, for example, an electric resistance heater with an electric heating wire. The supply valve 42, the flow rate regulation valve 43, and the heater 44 are controlled by the controller 90.

When the supply valve 42 is opened and the heater 44 operates, the heating medium at a high temperature is dispensed from the nozzle 40 toward the center of the second main surface Wb of the substrate W. The heating medium that lands on the center of the second main surface Wb of the substrate W flows outward in the radial direction along the second main surface Wb by centrifugal force of rotation of the substrate W, and flies off from the peripheral edge of the substrate W. When the heating medium at a high temperature flows along the second main surface Wb of the substrate W, heat is transferred from the heating medium to the substrate W, and the substrate W is heated.

In the example of FIG. 3, the guards 7 and a guard lifting driver 71 are provided for the processing unit 1. The guards 7 are of a tubular shape with respect to the rotation axis line Q1 as a central axis, and surround the substrate holder 2. The guards 7 can receive the processing liquid and the heating medium that fly off from the peripheral edge of the substrate W. The guard lifting driver 71 moves the guards 7 between an upper position and a lower position to be described next. The upper position is a position at which the upper end of each of the guards 7 is located above the substrate W held by the substrate holder 2. The guards 7 located at the upper positions can receive the processing liquid and the heating medium that fly off from the peripheral edge of the substrate W. The lower position is a position lower than the upper position, and is, for example, a position at which the upper end of each of the guards 7 is located vertically below the upper surface of the spin base 21.

In the example of FIG. 3, a plurality of the guards 7 are provided. The plurality of the guards 7 are concentrically disposed. The guards 7 may be used depending on each of the types of the processing liquids. In the example of FIG. 3, cups 72 corresponding to the respective guards 7 are provided. Each of the cups 72 includes a recess (a groove) that is of an annular shape (e.g., a circular shape) surrounding the rotation axis line Q1. Each of the cups 72 receives the processing liquid running down from the inner circumferential surface of a corresponding one of the guards 7. An upstream end of a discharge pipe 12 is connected to, for example, the bottom of each of the cups 72. The processing liquid received by each of the cups 72 is discharged outside the processing unit 1 through the discharge pipe 12.

### [Example operations of substrate processing apparatus]

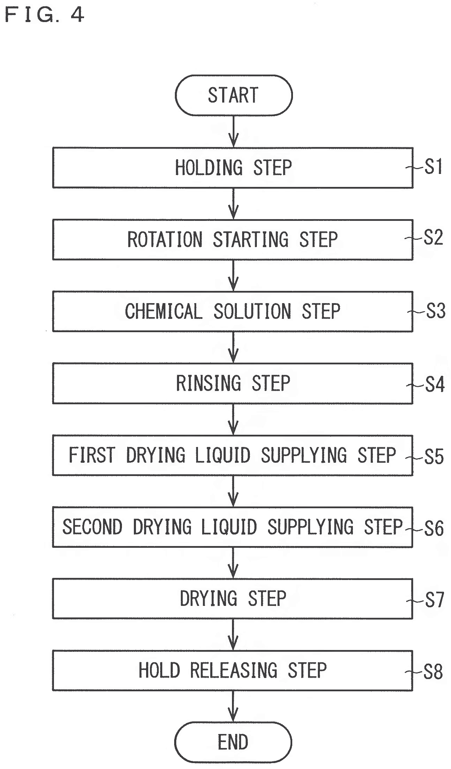

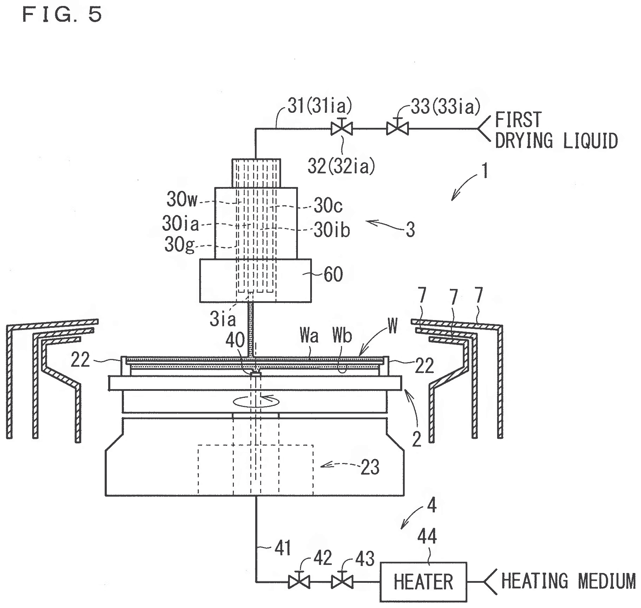

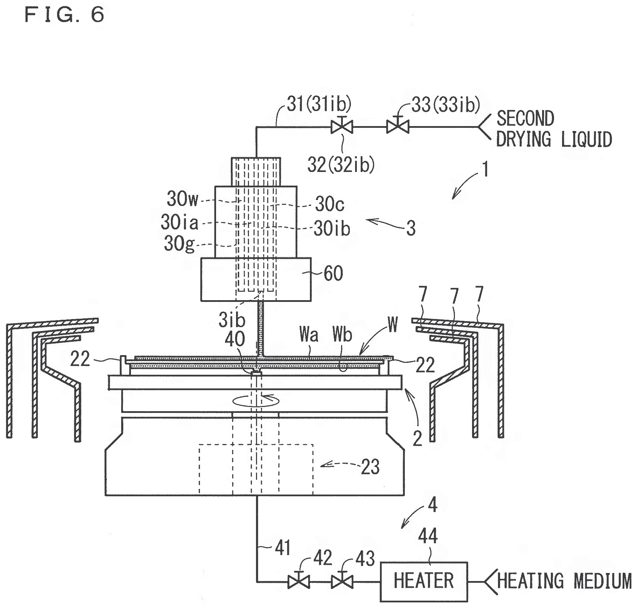

Next, example operations of the processing unit 1 will be described. FIG. 4 is a flowchart illustrating example operations of the processing unit 1. The controller 90 causes the processing unit 1 to execute processes from Step S1 to Step S8 according to a preset procedure (a recipe). FIG. 5 is a diagram schematically illustrating an example state of the processing unit 1 in a first drying liquid supplying step to be described later, and FIG. 6 is a diagram schematically illustrating an example state of the processing unit 1 in a second drying liquid supplying step to be described later.

First, the second transporter 122 transports the substrate W to the processing unit 1. Then, the substrate holder 2 holds the substrate W received from the second transporter 122 (Step S1: a holding step). As a specific example, the substrate holder 2 displaces the chuck pins 22 from the respective releasing positions to the holding positions. Consequently, the plurality of chuck pins 22 hold the substrate W. The substrate holder 2 continues to hold the substrate W until the end of the processes on the substrate W.

Next, the substrate holder 2 starts rotating the substrate W (Step S2: a rotation starting step). The substrate holder 2 may continue to rotate the substrate W until the end of the processes on the substrate W.

Next, the processing unit 1 supplies the first main surface Wa of the substrate W with a chemical solution (Step S3: a chemical solution step). First, the movement driver 35 moves the dispensing head to the processing position. Furthermore, the guard lifting driver 71 lifts the guard 7 for chemical solution to the upper position. Next, the controller 90 opens the supply valve 32c. In other words, the controller 90 switches the supply valve 32c from a close state to an open state. This causes the nozzle 30c to dispense the chemical solution toward the first main surface Wa of the rotating substrate W. The chemical solution that lands on the first main surface Wa of the substrate W flows outward in the radial direction by centrifugal force of rotation of the substrate W, and flies off from the peripheral edge of the substrate W. Here, the chemical solution acts on the first main surface Wa of the substrate W, so that the first main surface Wa of the substrate W is subjected to a chemical solution process corresponding to the type of the chemical solution. For example, the processing unit 1 performs a cleaning process of removing impurities on the first main surface Wa of the substrate W by cleaning or an etching process of etching a predetermined film on the first main surface Wa of the substrate W. The chemical solution that has flown off from the peripheral edge of the substrate W is received by the guard 7, and is discharged outside the chamber 10 through the discharge pipe 12.

After the processes on the substrate W have been sufficiently performed, the controller 90 closes the supply valve 32c. As a specific example, the controller 90 measures an elapsed time since start of dispensing the chemical solution, and determines whether the elapsed time is longer than or equal to a predetermined chemical solution time. The chemical solution time is preset to a time sufficient to perform the chemical solution process. For example, a timer circuit (not illustrated) belonging to the controller 90 measures the elapsed time. When the elapsed time is longer than or equal to the chemical solution time, the controller 90 switches the supply valve 32c from the open state to the close state.

Next, the processing unit 1 supplies the first main surface Wa of the substrate W with a rinse liquid (Step S4: a rinsing step). When the guard 7 for rinse liquid is different from the guard 7 for chemical solution, the guard lifting driver 71 appropriately lifts and lowers the guards 7 to lift the guard 7 for rinse liquid to the upper position. Then, the controller 90 opens the supply valve 32w. In other words, the controller 90 switches the supply valve 32w from the close state to the open state. This causes the nozzle 30w to dispense the rinse liquid toward the first main surface Wa of the rotating substrate W. The rinse liquid that lands on the first main surface Wa of the substrate W flows outward in the radial direction by centrifugal force of rotation of the substrate W, and flies off from the peripheral edge of the substrate W. Here, the rinse liquid forces the chemical solution out of the first main surface Wa of the substrate W outward in the radial direction. Consequently, the chemical solution used as the processing liquid on the first main surface Wa of the substrate W is replaced with the rinse liquid. The processing liquid that has flown off from the peripheral edge of the substrate W is received by the guard 7, and is discharged outside the chamber 10 through the discharge pipe 12.

After the chemical solution is sufficiently replaced with the rinse liquid, the controller 90 closes the supply valve 32w. As a specific example, the controller 90 measures an elapsed time since start of dispensing the rinse liquid, and switches the supply valve 32w from the open state to the close state when the elapsed time is longer than or equal to a predetermined rinsing time. The rinsing time is preset to a time sufficient to replace the chemical solution with the rinse liquid.

Next, the processing unit 1 supplies the first main surface Wa of the substrate W with the first drying liquid (Step S5: the first drying liquid supplying step). When the guard 7 for the first drying liquid is different from the guard 7 for rinse liquid, the guard lifting driver 71 appropriately lifts and lowers the guards 7 to lift the guard 7 for the first drying liquid to the upper position. Then, the controller 90 opens the supply valve 32ia. In other words, the controller 90 switches the supply valve 32ia from the close state to the open state.

When the supply valve 32ia is opened, the first drying liquid is dispensed from the outlet 3ia of the nozzle 30ia toward the first main surface Wa of the rotating substrate W as illustrated in FIG. 5. The temperature of the first drying liquid may be, for example, room temperature (for example, approximately 25 degrees centigrade). The temperature of the first drying liquid herein is, for example, a temperature of the first drying liquid at the outlet 3ia. Furthermore, examples of the room temperature herein include a temperature of the first drying liquid when a heater that heats the first drying liquid is not disposed upstream of the outlet 3ia or when no such heater operates. In other words, the room temperature includes a temperature of the first drying liquid that is not heated.

The first drying liquid from the nozzle 30ia lands on the center of the first main surface Wa of the substrate W. The first drying liquid that lands on the first main surface Wa flows outward in the radial direction by centrifugal force of rotation of the substrate W, and flies off from the peripheral edge of the substrate W. Here, the first drying liquid forces the rinse liquid out of the first main surface Wa of the substrate W, so that the rinse liquid used as the processing liquid on the first main surface Wa of the substrate W is replaced with the first drying liquid. The processing liquid that has flown off from the peripheral edge of the substrate W is received by the guard 7, and is discharged outside the chamber 10 through the discharge pipe 12.

Here, the rotation speed of the substrate W in the first drying liquid supplying step may be set to, for example, 150 rpm or higher and 600 rpm or lower, or 200 rpm or higher and 400 rpm or lower. As a specific example, the rotation speed can be set to 300 rpm. A flow rate of the first drying liquid is preset to, for example, approximately 100 mL/min or more, and can be set to, specifically, 250 mL/min or more.

Furthermore, the processing unit 1 heats the second main surface Wb of the substrate W when the first drying liquid is supplied. In other words, the substrate heating part 4 heats the second main surface Wb of the substrate W. As a specific example, the controller 90 opens the supply valve 42 and operates the heater 44. Consequently, the heating medium at a high temperature (e.g., hot water) is dispensed from the nozzle 40 toward the center of the second main surface Wb of the rotating substrate W as illustrated in FIG. 5. The heating medium that lands on the center of the second main surface Wb of the substrate W flows outward in the radial direction by centrifugal force of rotation of the substrate W, and flies off from the peripheral edge of the substrate W. When the heating medium at a high temperature flows along the second main surface Wb, heat is transferred from the heating medium to the substrate W, and the substrate W is heated. The heat of the substrate W is transferred to the first drying liquid on the first main surface Wa. This also heats the first drying liquid on the first main surface Wa of the substrate W, and increases the temperature of the first drying liquid.

The substrate heating part 4 heats the second main surface Wb of the substrate W to a first temperature (a first temperature value). The first temperature can be preset to a value corresponding to the first boiling point of the first drying liquid. Here, the second main surface Wb of the substrate W can have the next temperature distribution. In other words, a temperature at a liquid landing position (the center herein) of a heating medium is high in the temperature distribution, and the temperature decreases as a distance from the liquid landing position in the radial direction increases. The first temperature herein may be, for example, the maximum value in the temperature distribution. The first temperature may be 60 degrees centigrade or higher, 70 degrees centigrade or higher, or 80 degrees centigrade or higher. The first temperature may be lower than the first boiling point of the first drying liquid. As a specific example, the first temperature can be set to 80 degrees centigrade.

Specifically, the heater 44 heats the heating medium such that a temperature (hereinafter referred to as a medium temperature) of the heating medium becomes a first medium temperature (a first medium temperature value). The medium temperature of the heating medium is, for example, a temperature of the heating medium at an outlet of the nozzle 40. The first medium temperature may be, for example, 60 degrees centigrade or higher, 70 degrees centigrade or higher, or 80 degrees centigrade or higher. As a specific example, the first medium temperature can be set to 80 degrees centigrade. The first medium temperature may be lower than the first boiling point of the first drying liquid. For example, when the heating medium is water, the first medium temperature may be set lower than 90 degrees centigrade that is lower than a boiling point (100 degrees centigrade) of the heating medium by 10 degrees. This enables conformance to the SEMI standards.

The flow rate regulation valve 43 may regulate a flow rate of the heating medium to, for example, a value larger than a flow rate of the first drying liquid. Specifically, the flow rate regulation valve 43 may regulate the flow rate of the heating medium to 1000 mL/min or more, or 1500 mL/min or more.

As described above, the processing unit 1 supplies the first drying liquid to the first main surface Wa of the substrate W while heating the second main surface Wb of the substrate W in the first drying liquid supplying step. This increases the temperature of the first drying liquid on the first main surface Wa of the substrate W. Increasing the temperature of the first drying liquid can enhance the efficiency of replacing the rinse liquid with the first drying liquid.

After the rinse liquid is sufficiently replaced with the first drying liquid, the controller 90 closes the supply valve 32ia. As a specific example, the controller 90 measures an elapsed time since start of dispensing the first drying liquid, and switches the supply valve 32ia from the open state to the close state when the elapsed time is longer than or equal to a predetermined first drying liquid supply time. The first drying liquid supply time is preset to a time sufficient to replace the rinse liquid with the first drying liquid.

Next, the processing unit 1 supplies the first main surface Wa of the substrate W with the second drying liquid (Step S6: a second drying liquid supplying step). When the guard 7 for the second drying liquid is different from the guard 7 for the first drying liquid, the guard lifting driver 71 appropriately lifts and lowers the guards 7 to lift the guard 7 for the second drying liquid to the upper position. Then, the controller 90 opens the supply valve 32ib. In other words, the controller 90 switches the supply valve 32ib from the close state to the open state.

When the supply valve 32ib is opened, the second drying liquid is dispensed from the outlet 3ib of the nozzle 30ib toward the first main surface Wa of the rotating substrate W as illustrated in FIG. 6. The temperature of the second drying liquid may be, for example, room temperature (for example, 25 degrees centigrade). The temperature of the second drying liquid herein is, for example, a temperature of the second drying liquid at the outlet 3ib. Furthermore, examples of the room temperature herein include a temperature of the second drying liquid when a heater that heats the second drying liquid is not disposed upstream of the outlet 3ib or when no such heater operates. In other words, the room temperature includes a temperature of the second drying liquid that is not heated.

The second drying liquid from the nozzle 30ib lands on the center of the first main surface Wa of the substrate W. The second drying liquid that lands on the first main surface Wa flows outward in the radial direction by centrifugal force of rotation of the substrate W, and flies off from the peripheral edge of the substrate W. Here, the second drying liquid forces the first drying liquid out of the first main surface Wa of the substrate W, so that the first drying liquid used as the processing liquid on the first main surface Wa of the substrate W is replaced with the second drying liquid. The processing liquid that has flown off from the peripheral edge of the substrate W is received by the guard 7, and is discharged outside the chamber 10 through the discharge pipe 12.

Here, the rotation speed of the substrate W in the second drying liquid supplying step may be set to, for example, 150 rpm or higher and 600 rpm or lower, or 200 rpm or higher and 400 rpm or lower. As a specific example, the rotation speed can be set to 300 rpm. A flow rate of the second drying liquid is preset to, for example, approximately 100 mL/min or more, and can be set to, specifically, 250 mL/min or more.

Furthermore, the processing unit 1 heats the second main surface Wb of the substrate W when the second drying liquid is supplied. In other words, the substrate heating part 4 heats the second main surface Wb of the substrate W. As a specific example, the controller 90 opens the supply valve 42 and operates the heater 44. Consequently, the heating medium at a high temperature (e.g., hot water) is dispensed from the nozzle 40 toward the center of the second main surface Wb of the rotating substrate W as illustrated in FIG. 6. This heats the substrate W and also the second drying liquid on the first main surface Wa of the substrate W.

The substrate heating part 4 heats the second main surface Wb of the substrate W to a second temperature (a second temperature value). The second temperature can be preset to a value corresponding to the second boiling point of the second drying liquid. The second temperature is, for example, the maximum value in the temperature distribution of the second main surface Wb. As a specific example, the second boiling point of the second drying liquid is higher than the first boiling point of the first drying liquid. For example, when the first drying liquid and the second drying liquid are isopropyl alcohol and hydrofluoroolefin, respectively, the second boiling point (110.5 degrees centigrade) of the second drying liquid is higher than the first boiling point (82.4 degrees centigrade) of the first drying liquid. Here, the second temperature is set higher than a temperature (the first temperature herein) of the second main surface Wb of the substrate W in the first drying liquid supplying step. The second temperature may be, for example, 60 degrees centigrade or higher, 70 degrees centigrade or higher, or 80 degrees centigrade or higher. Furthermore, the second temperature may be higher than or equal to the first boiling point of the first drying liquid. The second temperature may be lower than the second boiling point of the second drying liquid. As a specific example, the second temperature can be set to approximately 89.9 degrees centigrade.

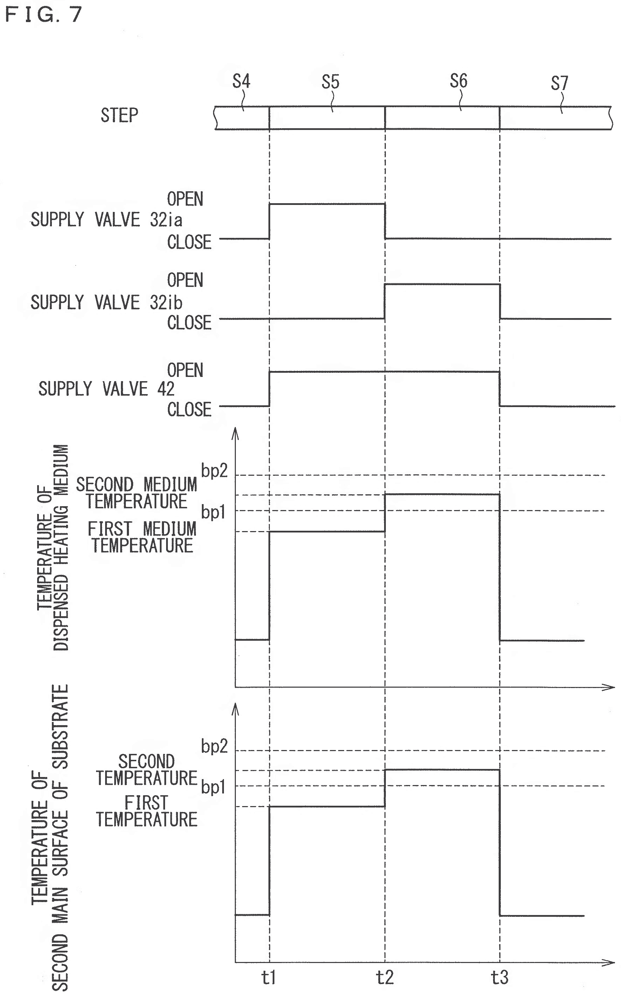

Specifically, the heater 44 heats the heating medium such that a medium temperature of the heating medium becomes a second medium temperature (a second medium temperature value). In the example of FIG. 7, the second medium temperature is higher than the medium temperature (the first medium temperature) of the heating medium in the first drying liquid supplying step. The second medium temperature may be, for example, 60 degrees centigrade or higher, 70 degrees centigrade or higher, or 80 degrees centigrade or higher. Furthermore, the second medium temperature may be higher than or equal to the first boiling point of the first drying liquid. The second medium temperature may be lower than the second boiling point of the second drying liquid. For example, when the heating medium is water, the second medium temperature may be set lower than 90 degrees centigrade that is lower than a boiling point (100 degrees centigrade) of the heating medium by 10 degrees. This enables conformance to the SEMI standards. As a specific example, the second medium temperature can be set to approximately 89.9 degrees centigrade.

The flow rate regulation valve 43 may regulate a flow rate of the heating medium to, for example, a value larger than a flow rate of the second drying liquid. Specifically, the flow rate regulation valve 43 may regulate a flow rate of the heating medium to 1000 mL/min or more, or 1500 mL/min or more.

As described above, the processing unit 1 supplies the second drying liquid to the first main surface Wa of the substrate W while heating the second main surface Wb of the substrate W in the second drying liquid supplying step. This increases the temperature of the second drying liquid on the first main surface Wa of the substrate W. Increasing the temperature of the second drying liquid can enhance the efficiency of replacing the first drying liquid with the second drying liquid.

After the first drying liquid is sufficiently replaced with the second drying liquid, the processing unit 1 dries the substrate W (Step S7: a drying step). Specifically, the processing unit 1 measures an elapsed time since start of dispensing the second drying liquid, and determines whether the elapsed time is longer than or equal to a predetermined second drying liquid supply time. The second drying liquid supply time is preset to a time sufficient to replace the first drying liquid with the second drying liquid. The second drying liquid supply time is set to, for example, approximately several tens of seconds or longer, and can be set to approximately 40 seconds as a specific example. Then, when the elapsed time is longer than or equal to the second drying liquid supply time, the processing unit 1 dries the substrate W. Specifically, the controller 90 closes the supply valve 32ib. Furthermore, the substrate heating part 4 stops heating the second main surface Wb of the substrate W.

Furthermore, the controller 90 causes the substrate holder 2 to increase the rotation speed of the substrate W. For example, the substrate holder 2 may rotate the substrate W at a rotation speed of 800 rpm or higher and 2500 rpm or lower, or at a rotation speed of 800 rpm or higher and 1500 rpm or lower. Furthermore, the substrate holder 2 may gradually (e.g., in stages) increase the rotation speed of the substrate W.

The processing unit 1 may supply the inert gas toward the center of the first main surface Wa of the substrate W. Specifically, the controller 90 may open the supply valve 32g and operate the heater 34g. This allows the inert gas at a high temperature to be dispensed from a gas outlet (i.e., the lower port of the gas passage 30g) at the center of the lower surface of the facing part 60 toward the center of the first main surface Wa of the substrate W. The inert gas that has impinged upon the center of the first main surface Wa of the substrate W flows outward in the radial direction along the first main surface Wa. The heater 34g may heat the inert gas to, for example, 60 degrees centigrade or higher, 70 degrees centigrade or higher, or 80 degrees centigrade or higher. The temperature of the inert gas may be, for example, a temperature of the inert gas at the gas outlet of the gas passage 30g. The flow rate regulation valve 33g may regulate a flow rate of the inert gas to, for example, 10 liters (L)/min or higher and 300 L/min or lower.

When the second drying liquid is sufficiently evaporated, the processing unit 1 stops the rotation of the substrate W while stopping the dispensing of the inert gas. As a specific example, the controller 90 measures an elapsed time since stopping the dispensing of the second drying liquid, and determines whether the elapsed time is longer than or equal to a predetermined drying time. The drying time is preset to a time sufficient to dry the substrate W. When the elapsed time is longer than or equal to the drying time, the controller 90 switches the supply valve 32g from the open state to the close state, and also causes the substrate holder 2 to stop rotating the substrate W. Furthermore, the movement driver 35 moves the dispensing head to the waiting position. The guard lifting driver 71 lowers the guards 7 to the lower positions.

Next, the substrate holder 2 releases a hold of the substrate W (Step S8: a hold releasing step). Then, the second transporter 122 unloads the processed substrate W from the processing unit 1.

As described above, the processing unit 1 can perform the processes on the substrate W. Moreover, the first drying liquid supplying step is performed after a liquid supplying step including the chemical solution step and the rinsing step, and then the second drying liquid supplying step is performed in this Embodiment. FIG. 7 is a diagram schematically illustrating a first example of a timing chart of the processing unit 1 according to Embodiment 1, time variations in medium temperature of the heating medium, and time variations in temperature of the second main surface Wb of the substrate W. In the example of FIG. 7, the maximum value in the temperature distribution of the second main surface Wb is indicated as the temperature of the second main surface Wb of the substrate W. This point will apply to the other drawings to be referenced to later.

In the example of FIG. 7, the controller 90 switches the supply valve 32ia from the close state to the open state at a time point t1. Consequently, the nozzle 30ia starts dispensing the first drying liquid toward the first main surface Wa of the substrate W. The first drying liquid supplying step is substantially started at this time point t1. In other words, a process of replacing the rinse liquid with the first drying liquid is started. Since the miscibility between the rinse liquid and the first drying liquid is higher than that between the rinse liquid and the second drying liquid, the rinse liquid used as the processing liquid on the substrate W can be replaced with the first drying liquid with higher replacement efficiency than that when the rinse liquid is replaced with the second drying liquid.

The controller 90 switches the supply valve 42 from the close state to the open state, for example, at the time point t1 to operate the heater 44. Consequently, the heating medium at a high temperature is dispensed from the nozzle 40 toward the second main surface Wb of the substrate W to heat the substrate W. This can also heat the first drying liquid on the first main surface Wa of the substrate W. Since the temperature of the first drying liquid on the first main surface Wa of the substrate W is high, the efficiency of replacing the rinse liquid with the first drying liquid can be enhanced. Thus, a residual volume of the rinse liquid with a high surface tension can be further reduced at the end of the first drying liquid supplying step.

In the example of FIG. 7, the medium temperature (the first medium temperature) of the heating medium in the first drying liquid supplying step is lower than a first boiling point bp1 of the first drying liquid. Thus, the temperature of the first main surface Wa of the substrate W is also lower than the first boiling point bp1. This can more reliably suppress a boil of the first drying liquid on the first main surface Wa of the substrate W. If the first drying liquid on the first main surface Wa comes to a boil in supplying the first drying liquid, particles adhere to the first main surface Wa. In the aforementioned example, since a boil of the first drying liquid can be more reliably suppressed, adherence of particles can be more reliably suppressed.

In the example of FIG. 7, the controller 90 switches the supply valve 32ia from the open state to the close state, and also switches the supply valve 32ib from the close state to the open state at a time point t2. The second drying liquid supplying step is substantially started at this time point t2. In other words, a process of replacing the first drying liquid with the second drying liquid is started. Since the miscibility between the first drying liquid and the second drying liquid is higher than that between the rinse liquid and the second drying liquid, the first drying liquid used as the processing liquid on the substrate W can be replaced with the second drying liquid with higher replacement efficiency than that when the rinse liquid is replaced with the second drying liquid.

In the example of FIG. 7, the supply valve 42 is open after the time point t2. Consequently, the heating medium at a high temperature is dispensed from the nozzle 40 toward the second main surface Wb of the substrate W to heat the substrate W. This can also heat the second drying liquid on the first main surface Wa of the substrate W. In the example of FIG. 7, a second boiling point bp2 of the second drying liquid is higher than the first boiling point bp1 of the first drying liquid. Thus, the second temperature is set higher than the first temperature. In other words, the substrate heating part 4 heats the second main surface Wb of the substrate W to the first temperature that is lower to correspond to the lower first boiling point bp1 of the first drying liquid in the first drying liquid supplying step, and heats the second main surface Wb of the substrate W to the second temperature that is higher to correspond to the higher second boiling point bp2 of the second drying liquid in the second drying liquid supplying step. In other words, the heater 44 increases an amount of heat to be given to the heating medium to increase the medium temperature of the heating medium from the first medium temperature to the second medium temperature at the time point t2.

This can further increase the temperature of the second drying liquid on the first main surface Wa of the substrate W in the second drying liquid supplying step. In other words, the temperature of the second drying liquid on the first main surface Wa of the substrate W can be brought closer to the second boiling point bp2. Thus, the efficiency of replacing the first drying liquid with the second drying liquid can be further enhanced, and the residual volume of the first drying liquid with a high surface tension can be further reduced at the end of the second drying liquid supplying step. In the example of FIG. 7, the second medium temperature of the heating medium is higher than or equal to the first boiling point bp1 of the first drying liquid, and the second temperature of the second main surface Wb of the substrate W is also higher than or equal to the first boiling point bp1 of the first drying liquid. Thus, the temperature of the second drying liquid on the first main surface Wa of the substrate W can be increased to a higher temperature. In other words, the temperature of the second drying liquid on the first main surface Wa of the substrate W can be brought closer to the second boiling point bp2, and the efficiency of replacing the first drying liquid with the second drying liquid can be further enhanced.

In the example of FIG. 7, since the second medium temperature of the heating medium is lower than the second boiling point bp2 of the second drying liquid, the temperature of the first main surface Wa of the substrate W is lower than the second boiling point bp2. This can more reliably suppress a boil of the second drying liquid on the first main surface Wa of the substrate W. Thus, adherence of particles can be more reliably suppressed.

Then, in the drying step, evaporation of the second drying liquid on the first main surface Wa of the substrate W dries the substrate W. First, the surface tension of the second drying liquid is lower than that of the first drying liquid in view of liquid materials. Thus, a pattern collapse ratio of the first main surface Wa of the substrate W in the drying can be reduced.

Furthermore, the first drying liquid supplying step is performed after the liquid supplying step, and then the second drying liquid supplying step is performed. In other words, the rinse liquid is replaced with the first drying liquid with higher miscibility with the rinse liquid in the first drying liquid supplying step, and then, the first drying liquid is replaced with the second drying liquid with higher miscibility with the first drying liquid in the second drying liquid supplying step. Thus, the rinse liquid can be replaced with the first drying liquid, and the first drying liquid can be replaced with the second drying liquid with higher replacement efficiency in view of the liquid materials. Consequently, the residual volume of the rinse liquid and the first drying liquid with high surface tensions can be further reduced at the end of the second drying liquid supplying step. This can also reduce the pattern collapse ratio.

Furthermore, since the first drying liquid on the first main surface Wa of the substrate W is heated in the first drying liquid supplying step, the rinse liquid used as the processing liquid on the substrate W is replaced with the first drying liquid with higher replacement efficiency. Consequently, the residual volume of the rinse liquid can be reduced at the end of the second drying liquid supplying step also in view of the temperature.

Furthermore, since the second drying liquid on the first main surface Wa of the substrate W is heated to a higher temperature in the second drying liquid supplying step, the residual volume of the first drying liquid can be reduced. This can also reduce the pattern collapse ratio. Moreover, the second drying liquid is evaporated at a higher temperature in the drying step. Thus, the second drying liquid can be evaporated in a shorter period. Since a surface tension is lower as the temperature is higher, the second drying liquid is evaporated at a low surface tension. As such, a decrease in the surface tension and an increase in the evaporation rate which depend on the temperature can also reduce the pattern collapse ratio.

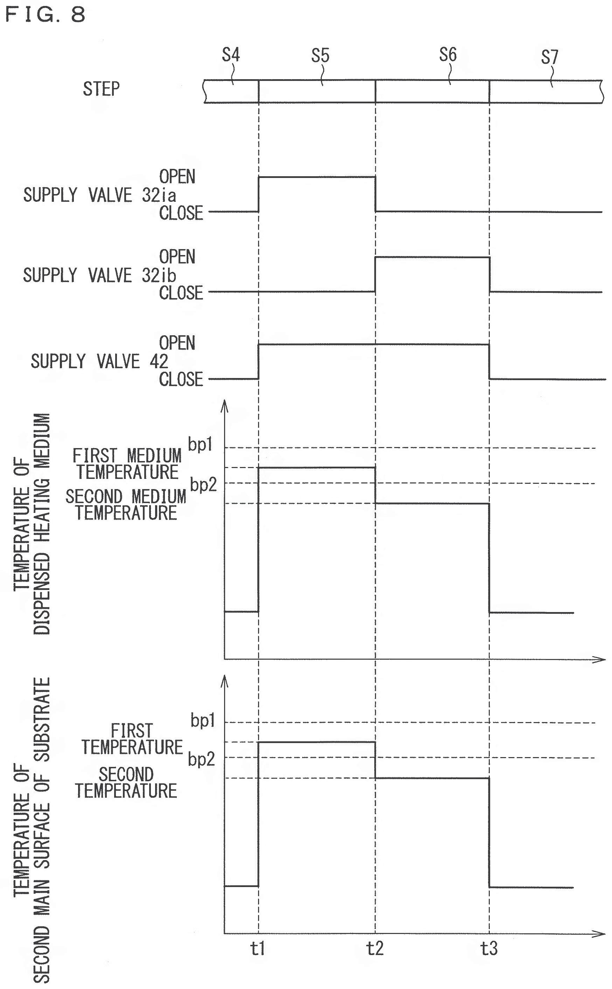

While the aforementioned examples describe that the first boiling point bp1 of the first drying liquid is lower than the second boiling point bp2 of the second drying liquid, the first boiling point bp1 of the first drying liquid may be higher than the second boiling point bp2 of the second drying liquid. FIG. 8 is a diagram schematically illustrating a second example of the timing chart of the processing unit 1 according to Embodiment 1, time variations in medium temperature of the heating medium, and time variations in temperature of the second main surface Wb of the substrate W.

In the example of FIG. 8, the first boiling point bp1 of the first drying liquid is higher than the second boiling point bp2 of the second drying liquid. For example, when the first drying liquid and the second drying liquid are isopropyl alcohol and fluoroheptene, respectively, the first boiling point bp1 (82.4 degrees centigrade) of the first drying liquid is higher than the second boiling point bp2 (71.5 degrees centigrade) of the second drying liquid.

Here, the substrate heating part 4 heats the second main surface Wb of the substrate W to the second temperature lower than the first temperature in the second drying liquid supplying step. To summarize the examples of FIGS. 7 and 8, the first temperature is lower than the second temperature when the first boiling point bp1 is lower than the second boiling point bp2, and the first temperature is higher than the second temperature when the first boiling point bp1 is higher than the second boiling point bp2. In other words, a positive or negative sign of a value obtained by subtracting the second temperature from the first temperature is equal to a positive or negative sign of a value obtained by subtracting the second boiling point bp2 of the second drying liquid from the first boiling point bp1 of the first drying liquid.

In the example of FIG. 8, the first medium temperature is higher than the second medium temperature. This can make the first temperature higher than the second temperature. To summarize the examples of FIGS. 7 and 8, a positive or negative sign of a value obtained by subtracting the second temperature from the first temperature is equal to a positive or negative sign of a value obtained by subtracting the second medium temperature from the first medium temperature.

In the example of FIG. 8, the temperature of the second main surface Wb of the substrate W is regulated to the first temperature that is higher in the first drying liquid supplying step. Thus, the temperature of the first drying liquid on the first main surface Wa of the substrate W can be brought closer to the first boiling point bp1. Consequently, the rinse liquid used as the processing liquid on the first main surface Wa of the substrate W can be replaced with the first drying liquid with higher replacement efficiency in the first drying liquid supplying step.

On the other hand, the temperature of the second main surface Wb of the substrate W is regulated to the second temperature lower than the first temperature in the second drying liquid supplying step. Thus, a boil of the second drying liquid on the second main surface Wb can be further suppressed in the second drying liquid supplying step. Moreover, since the substrate W is heated, the first drying liquid is replaced with the second drying liquid with higher replacement efficiency than that when the substrate W is not heated.

In the example of FIG. 8, the first temperature is higher than or equal to the second boiling point bp2 of the second drying liquid. To summarize the examples of FIGS. 7 and 8 in this respect, a higher one of the first temperature and the second temperature (the second temperature in FIG. 7, and the first temperature in FIG. 8) is higher than or equal to a lower one of the first boiling point bp1 and the second boiling point bp2 (the first boiling point bp1 in FIG. 7, and the second boiling point bp2 in FIG. 8). In the example of FIG. 8, since the first temperature is higher than or equal to the second boiling point bp2, the first drying liquid on the first main surface Wa of the substrate W can be increased to a higher temperature in the first drying liquid supplying step. Thus, the rinse liquid used as the processing liquid on the first main surface Wa of the substrate W can be replaced with the first drying liquid with higher replacement efficiency.

In the example of FIG. 8, the first temperature is lower than the first boiling point bp1 of the first drying liquid, and the second temperature is lower than the second boiling point bp2 of the second drying liquid. Thus, a boil of the first drying liquid in the first drying liquid supplying step can be more reliably suppressed, and a boil of the second drying liquid in the second drying liquid supplying step can be more reliably suppressed. Thus, adherence of particles can be more reliably suppressed.

Furthermore, the substrate heating part 4 supplies the heating medium to the second main surface Wb of the substrate W to heat the substrate W. Consequently, the substrate heating part 4 can heat the second main surface Wb of the substrate W with a simple structure. Specifically, the substrate heating part 4 can heat, with a simple structure, the second main surface Wb of the substrate W to each of the first temperature corresponding to the first boiling point bp1 of the first drying liquid and the second temperature corresponding to the second boiling point bp2 of the second drying liquid.

In Embodiment 1 above, the substrate heating part 4 heats the second main surface Wb of the substrate W in the entirety of the first drying liquid supplying step. In other words, the substrate heating part 4 heats the second main surface Wb of the substrate W over the entirety of the first drying liquid supply time. However, the substrate heating part 4 may heat the second main surface Wb of the substrate W in at least a part of the time of the first drying liquid supplying step. Since the temperature of the first drying liquid on the first main surface Wa of the substrate W can be increased in the part of the time, the replacement efficiency in the part of the time can be improved. Similarly, the substrate heating part 4 may heat the second main surface Wb of the substrate W in at least a part of the time of the second drying liquid supplying step.

While the dispenser 3 dispenses the first drying liquid and the second drying liquid at room temperature in the aforementioned examples, the dispenser 3 may dispense the first drying liquid at a high temperature or the second drying liquid at a high temperature. For example, the dispenser 3 may further include at least one of a first heater (not illustrated) and a second heater (not illustrated). The first heater is disposed in the supply pipe 31ia, and heats the first drying liquid flowing through the supply pipe 31ia. The second heater is disposed in the supply pipe 31ib, and heats the second drying liquid flowing through the supply pipe 31ib. The first heater and the second heater are controlled by the controller 90. The first heater heats the first drying liquid such that the temperature of the first drying liquid is higher than room temperature and lower than the first boiling point bp1 of the first drying liquid. The first heater may increase the temperature of the first drying liquid to, for example, 60 degrees centigrade or higher, and approximately 70 degrees centigrade as a specific example. The second heater heats the second drying liquid such that the temperature of the second drying liquid is higher than room temperature and lower than the second boiling point bp2 of the second drying liquid. The second heater may increase the temperature of the second drying liquid to, for example, 60 degrees centigrade or higher, and approximately 70 degrees centigrade as a specific example.

### <Embodiment 2>

A structure of the substrate processing apparatus 100 according to Embodiment 2 is identical to that according to Embodiment 1. In Embodiment 2, the substrate heating part 4 may heat at least a part (e.g., the center) of the second main surface Wb of the substrate W to the first boiling point bp1 of the first drying liquid or higher in the first drying liquid supplying step (Step S5). Specifically, the substrate heating part 4 may supply the heating medium higher than or equal to the first boiling point bp1 of the first drying liquid to the center of the second main surface Wb of the substrate W. Alternatively, the substrate heating part 4 may heat at least a part (e.g., the center) of the second main surface Wb of the substrate W to the second boiling point bp2 of the second drying liquid or higher in the second drying liquid supplying step (Step S6). Specifically, the substrate heating part 4 may supply the heating medium higher than or equal to the second boiling point bp2 of the second drying liquid to the center of the second main surface Wb of the substrate W. Following is the specific description.

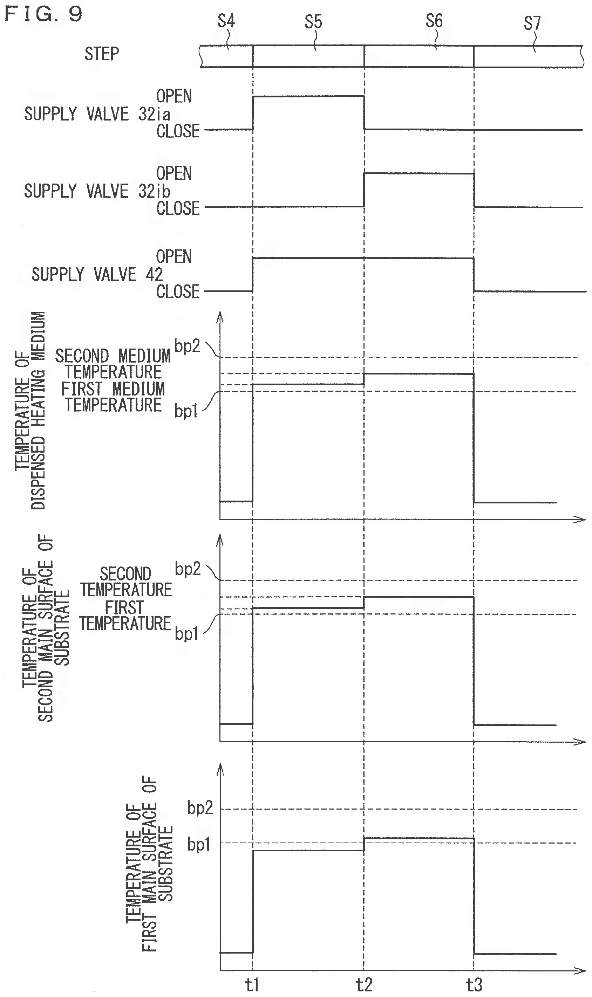

FIG. 9 is a diagram schematically illustrating a first example of a timing chart of the processing unit 1 according to Embodiment 2, time variations in medium temperature of the heating medium, time variations in temperature of the second main surface Wb of the substrate W, and time variations in temperature of the first main surface Wa of the substrate W. In the example of FIG. 9, the first boiling point bp1 of the first drying liquid is lower than the second boiling point bp2 of the second drying liquid.

In the example of FIG. 9, the first medium temperature of the heating medium dispensed from the nozzle 40 is higher than the first boiling point bp1 of the first drying liquid in the first drying liquid supplying step (Step S5). When the first drying liquid is isopropyl alcohol, the first boiling point bp1 is 82.4 degrees centigrade, and the first medium temperature of the heating medium is set to, for example, approximately 85 degrees centigrade. Thus, the temperature of a portion (e.g., the center) on which the heating medium lands on the second main surface Wb of the substrate W is also higher than the boiling point of the first drying liquid.

In the first drying liquid supplying step, the first drying liquid lower in temperature than the heating medium is dispensed from the nozzle 30ia. Thus, the first drying liquid at a low temperature is continuously supplied to the first main surface Wa of the substrate W. Thus, the first drying liquid at a low temperature can cool the first main surface Wa of the substrate W. The cooling capacity of this first drying liquid increases as a flow rate of the first drying liquid is higher. Here, the flow rate regulation valve 33ia regulates the flow rate of the first drying liquid to a value with which the temperature of the first main surface Wa of the substrate W is lower than the first boiling point bp1. A flow rate of the first drying liquid is preset to, for example, approximately 100 mL/min or more, and can be set to, specifically, 250 mL/min or more.

In the example of FIG. 9, the temperature at the center of the first main surface Wa of the substrate W is indicated as the temperature of the first main surface Wa of the substrate W. Since the heating medium at a high temperature lands on the center of the second main surface Wb of the substrate W, the temperature of the first main surface Wa of the substrate W has a temperature distribution to be described next. In other words, the temperature is high at the center of the substrate W, and decreases outward in the radial direction. In the example of FIG. 9, the highest value in the temperature distribution of the first main surface Wa of the substrate W is indicated as the temperature of the first main surface Wa.

As illustrated in FIG. 9, the temperature of the first main surface Wa of the substrate W in the first drying liquid supplying step is lower than the first boiling point bp1 of the first drying liquid. When the first drying liquid is isopropyl alcohol, the highest temperature in the temperature distribution of the first main surface Wa of the substrate W can be regulated to, for example, approximately 80 degrees centigrade or lower. Thus, a boil of the first drying liquid in the first drying liquid supplying step can be more reliably suppressed. Thus, adherence of particles to the first main surface Wa of the substrate W can be more reliably suppressed.

Moreover, the first medium temperature of the heating medium dispensed in the first drying liquid supplying step is higher than or equal to the first boiling point bp1 in the aforementioned examples. Thus, the maximum value in the temperature distribution on the first main surface Wa of the substrate W can be brought closer to the first boiling point bp1 in the first drying liquid supplying step.

In Embodiment 2, the temperature of the first drying liquid on the first main surface Wa of the substrate W can be brought closer to the first boiling point bp1 while the temperature of the substrate W itself is set higher in the first drying liquid supplying step. Thus, the rinse liquid used as the processing liquid on the first main surface Wa of the substrate W can be replaced with the first drying liquid with higher replacement efficiency. Consequently, a residual volume of the rinse liquid can be further reduced, and the pattern collapse ratio can be further reduced.

In the example of FIG. 9, the second medium temperature of the heating medium dispensed from the nozzle 40 is lower than the second boiling point bp2 of the second drying liquid in the second drying liquid supplying step (Step S6). Here, the second drying liquid is methoxyperfluoroheptene, and the heating medium is water. In other words, the second boiling point bp2 is 110.5 degrees centigrade, and the boiling point of the heating medium is 100 degrees centigrade. Thus, the second boiling point bp2 is higher than the boiling point of the heating medium. Since the medium temperature of the heating medium needs to be set lower than the boiling point of the heating medium, the second medium temperature of the heating medium in the second drying liquid supplying step is set to approximately 89.9 degrees centigrade, for example, similarly to Embodiment 1. Thus, the second temperature is also lower than the boiling point of the heating medium, and is further lower than the second boiling point bp2 of the second drying liquid.

Since the second temperature is higher than the first temperature also in the example of FIG. 9, the temperature of the second drying liquid on the first main surface Wa of the substrate W can be higher in the second drying liquid supplying step, similarly to Embodiment 1. This can reduce the pattern collapse ratio, similarly to Embodiment 1.

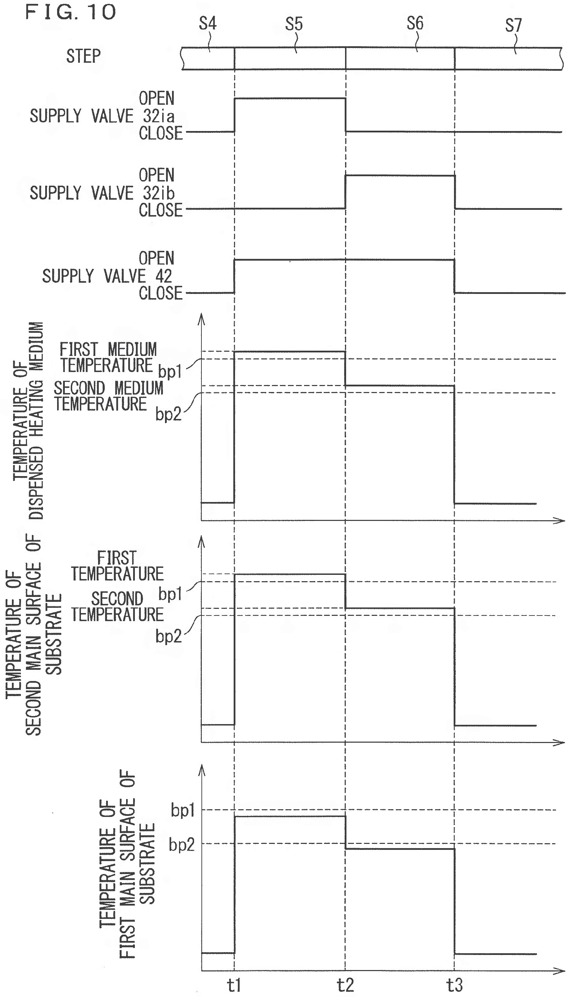

Next, a case where the first boiling point bp1 is higher than the second boiling point bp2 will be described. FIG. 10 is a diagram schematically illustrating a second example of a timing chart of the processing unit 1 according to Embodiment 2, time variations in medium temperature of the heating medium, time variations in temperature of the second main surface Wb of the substrate W, and time variations in temperature of the first main surface Wa of the substrate W. In the example of FIG. 10, the first boiling point bp1 of the first drying liquid is higher than the second boiling point bp2 of the second drying liquid. The second drying liquid supplying step (Step S6) is different compared to FIG.9.

In the example of FIG. 10, the substrate heating part 4 heats at least a part (the center herein) of the second main surface Wb of the substrate W to the second boiling point bp2 of the second drying liquid or higher in the second drying liquid supplying step (Step S6). Since the second boiling point bp2 is lower than the first boiling point bp1, the substrate heating part 4 heats the second main surface Wb of the substrate W to the second temperature lower than the first temperature in the example of FIG. 10, similarly to Embodiment 1. Specifically, the second medium temperature of the heating medium dispensed from the nozzle 40 is lower than the first medium temperature, and is higher than the second boiling point bp2 of the second drying liquid. Here, the second drying liquid is fluoroheptene, and the second boiling point bp2 is 71.5 degrees centigrade. The second medium temperature of the heating medium can be set to approximately 75 degrees centigrade.

In the second drying liquid supplying step, the second drying liquid lower in temperature than the heating medium is dispensed from the nozzle 30ib. The cooling capacity of this second drying liquid increases as a flow rate of the second drying liquid is higher. Here, the flow rate regulation valve 33ib regulates the flow rate of the second drying liquid to a value with which the temperature of the first main surface Wa of the substrate W is lower than the second boiling point bp2. The flow rate of the second drying liquid is preset to, for example, approximately 100 mL/min or more, and can be set to, specifically, 250 mL/min or more.

As illustrated in FIG. 10, the temperature of the first main surface Wa of the substrate W in the second drying liquid supplying step is lower than the second boiling point bp2 of the second drying liquid. The highest temperature in the temperature distribution of the first main surface Wa of the substrate W can be regulated to, for example, approximately 70 degrees centigrade or lower. Thus, a boil of the second drying liquid in the second drying liquid supplying step can be more reliably suppressed. Consequently, adherence of particles to the first main surface Wa of the substrate W can be more reliably suppressed.

Moreover, the second medium temperature of the heating medium dispensed in the second drying liquid supplying step is higher than or equal to the second boiling point bp2 in the aforementioned examples. Thus, the maximum value in the temperature distribution on the first main surface Wa of the substrate W can be brought closer to the second boiling point bp2 in the second drying liquid supplying step. Consequently, the first drying liquid used as the processing liquid on the first main surface Wa of the substrate W can be replaced with the second drying liquid with higher replacement efficiency. Furthermore, the temperature of the second drying liquid on the first main surface Wa of the substrate W can be further increased in the drying step immediately after supply of the second drying liquid is stopped. Thus, the surface tension of the second drying liquid can be further reduced, and an evaporation rate of the second drying liquid can be further increased in the drying step. This can further reduce the pattern collapse ratio.

### <Embodiment 3>

In the specific examples of Embodiments 1 and 2, the substrate heating part 4 heats the second main surface Wb of the substrate W to the second temperature during the entirety of the second drying liquid supply time in the second drying liquid supplying step (Step S6). However, it is not always limited to this.

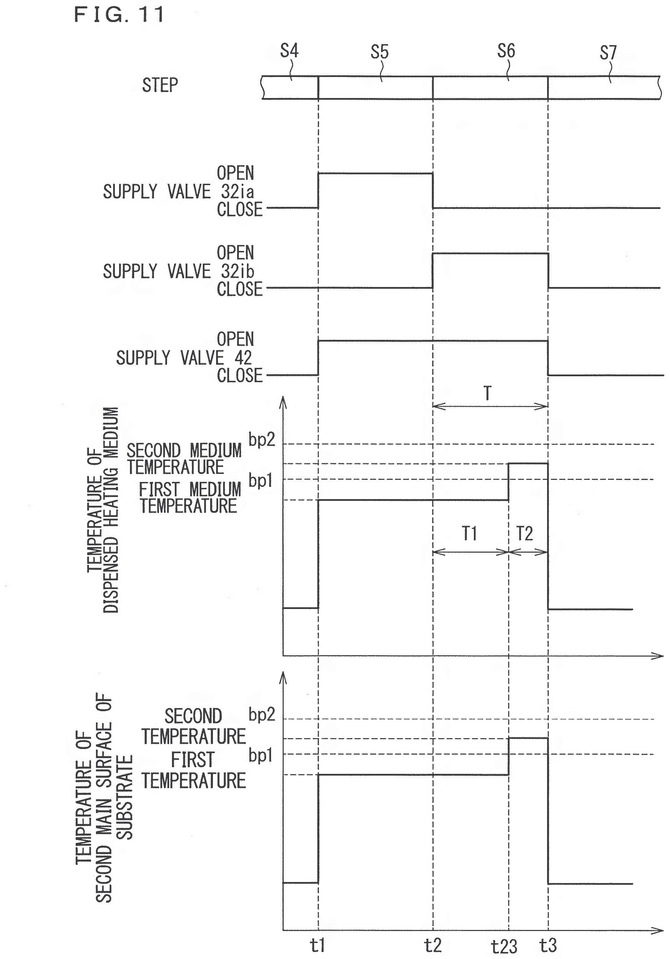

FIG. 11 is a diagram schematically illustrating an example of a timing chart of the processing unit 1 according to Embodiment 3, time variations in medium temperature of the heating medium, and time variations in temperature of the second main surface Wb of the substrate W. In the example of FIG. 11, the second boiling point bp2 of the second drying liquid is higher than the first boiling point bp1 of the first drying liquid. Thus, the second temperature is higher than the first temperature in the example of FIG. 11.

In the example of FIG. 11, the medium temperature of the heating medium is maintained at the first medium temperature even after the time point t2, and is increased from the first medium temperature to the second medium temperature at a time point t23 after the time point t2. In other words, the controller 90 causes the heater 44 to increase the medium temperature of the heating medium at the time point t23. Specifically, the heater 44 increases an amount of heat to be given to the heating medium at the time point t23 to increase the medium temperature of the heating medium from the first medium temperature to the second medium temperature. Then, the controller 90 switches the supply valve 42 from the open state to the close state at a time point t3 after the time point t23.

Thus, the substrate heating part 4 heats the second main surface Wb of the substrate W to the second temperature in a predetermined latter period T2 from the time point t23 to the time point t3 in a second drying liquid supply time T from the time point t2 to the time point t3. In the example of FIG. 11, the temperature of the second main surface Wb of the substrate W in a former period T1 from the time point t2 to the time point t23 is lower than the second temperature, and can be maintained at the first temperature as a specific example. The latter period T2 is preset to a time sufficient to bring the temperature of the first main surface Wa of the substrate W at the time point t3 closer to the second boiling point bp2 of the second drying liquid. For example, the latter period T2 may be set to half the second drying liquid supply time T or less, or one third, one fourth, or one tenth of the second drying liquid supply time T or less.

As described above, the substrate heating part 4 heats the second main surface Wb of the substrate W to the second temperature in the latter period T2, and sets the temperature of the second main surface Wb of the substrate W lower than the second temperature in the former period T1 in Embodiment 3. Thus, the power consumption of the substrate heating part 4 can be reduced, and the power consumption of the substrate processing apparatus 100 can be reduced. Since the temperature of the second drying liquid on the first main surface Wa of the substrate W at the time point t3 is sufficiently higher, the second drying liquid can be evaporated with a low surface tension and in a short evaporation period in the drying step. This can reduce the pattern collapse ratio.

While the substrate heating part 4 supplies a heating medium at a high temperature to the second main surface Wb of the substrate W in the former period T1 in the example of FIG. 11, the substrate heating part 4 need not heat the second main surface Wb of the substrate W in the former period T1. In this case, the substrate heating part 4 does not supply a heating medium. Thus, the usage of the heating medium can be reduced. When the heating medium is liquid, the liquid can be saved. The replacement efficiency can be enhanced in the latter period T2 after the first drying liquid has been replaced with the second drying liquid to some extent. Thus, the residual volume of the first drying liquid is reduced more easily than that when the second main surface Wb of the substrate W is heated to the second temperature in the former period T1.

### <Embodiment 4>

In the aforementioned examples, the processing unit 1 performs the chemical solution step (Step S3), the rinsing step (Step S4), the first drying liquid supplying step (Step S5), the second drying liquid supplying step (Step S6), and the drying step (Step S7) in this order. However, it is not always limited to this.

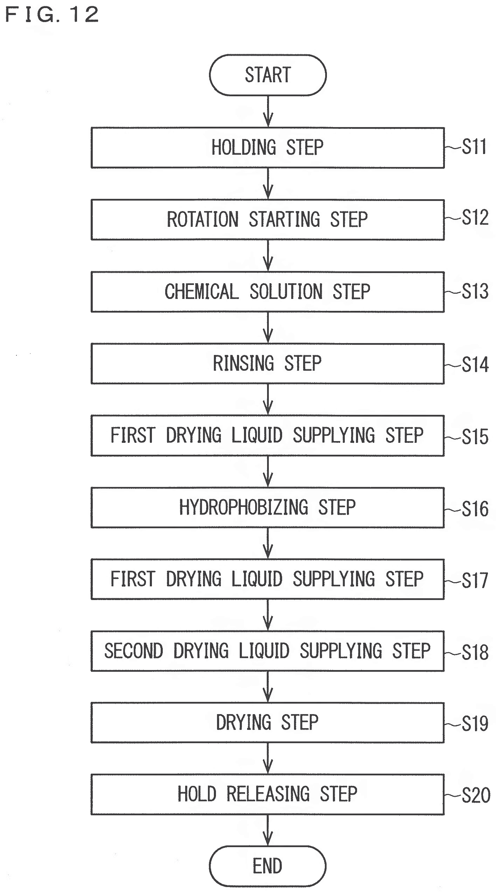

FIG. 12 is a flowchart illustrating first example operations of the processing unit 1 according to Embodiment 4. In the example of FIG. 12, the controller 90 causes the processing unit 1 to execute processes from Step S11 to Step S20 according to a preset procedure (a recipe). Steps S11 to S15 are identical to Steps S1 to S5. In Step S15 (the first drying liquid supplying step), the substrate heating part 4 need not heat the substrate W.

Next, the processing unit 1 makes the first main surface Wa of the substrate W hydrophobic (Step S16: a hydrophobizing step corresponding to a liquid supplying step). Specifically, the processing unit 1 includes a nozzle that dispenses a hydrophobizing solution, and dispenses the hydrophobizing solution from the nozzle to the first main surface Wa of the rotating substrate W. Examples of the hydrophobizing solution include a silicon-based hydrophobizing solution. The silicon-based hydrophobizing solution is a hydrophobizing solution that make silicon (Si) per se and a compound containing silicon hydrophobic. The hydrophobizing solution is, for example, a silylation solution containing a silylation agent (also referred to as a silane coupling agent) in a liquid state. The processing unit 1 stops dispensing the hydrophobizing solution from the nozzle when the first main surface Wa of the substrate W is sufficiently made hydrophobic.

Next, the processing unit 1 executes Step S17 to Step S20. Steps S17 to S20 are identical to Steps S5 to S8.

As described above, the first drying liquid supplying step (Step S17) and the second drying liquid supplying step (Step S18) are also executed in the aforementioned first example, similarly to the first drying liquid supplying step (Step S5) and the second drying liquid supplying step (Step S6) in each of Embodiments 1 to 3. This can reduce the pattern collapse ratio of the substrate W. Moreover, since the first main surface Wa of the substrate W is made hydrophobic, a contact angle of the first main surface Wa can be reduced. This can reduce the surface tension acting on a pattern, and can further reduce a pattern collapse ratio.

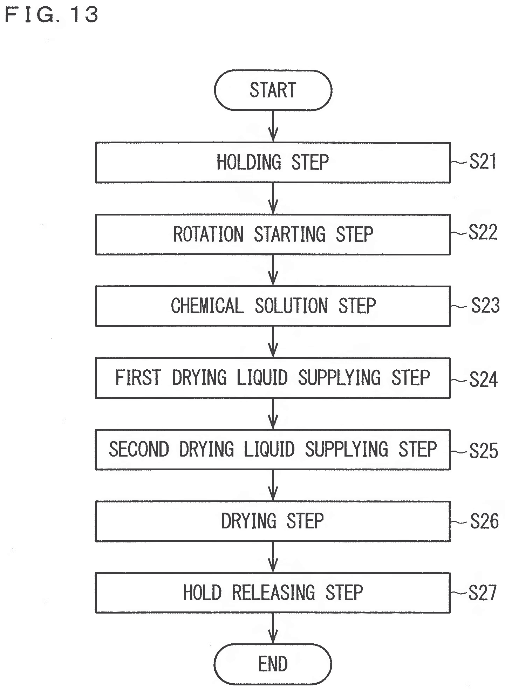

FIG. 13 is a flowchart illustrating second example operations of the processing unit 1 according to Embodiment 4. In the example of FIG. 13, the controller 90 causes the processing unit 1 to execute processes from Step S21 to Step S27 according to a preset procedure (a recipe). Steps S21 to S27 are identical to Steps S1 to S3 and Steps S5 to S8. A metal is exposed on the first main surface Wa of the substrate W at the end of Step S23 (the chemical solution step corresponding to the liquid supplying step). In the second example, Step S24 (the first drying liquid supplying step) is performed after Step S23. Thus, no water is supplied to the first main surface Wa of the substrate W. This can avoid a reaction between the metal and water, and avoid a malfunction caused by the reaction. Furthermore, the first drying liquid supplying step (Step S24) and the second drying liquid supplying step (Step S25) are also executed in the aforementioned second example, similarly to the first drying liquid supplying step (Step S5) and the second drying liquid supplying step (Step S6) in each of Embodiments 1 to 3. This can reduce the pattern collapse ratio of the substrate W.

### <Embodiment 5>

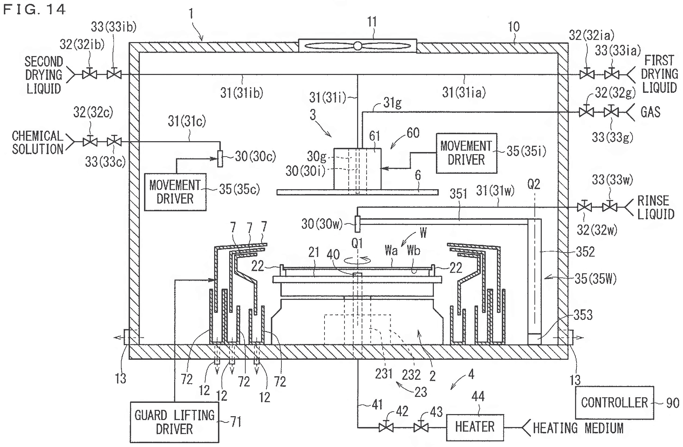

FIG. 14 is a diagram schematically illustrating an example structure of the processing unit 1 according to Embodiment 5. The processing unit 1 according to Embodiment 5 differs from that according to Embodiment 1 in the structure of the dispenser 3 and the facing part 60. In the example of FIG. 14, the facing part 60 includes a baffle plate 6 and a hollow shaft 61. The baffle plate 6 is disposed at a position facing the first main surface Wa of the substrate W held by the substrate holder 2 in the vertical direction. Since the first main surface Wa of the substrate W corresponds to the upper surface in the example of FIG. 14, the baffle plate 6 is disposed vertically above the substrate W. The baffle plate 6 is, for example, plate-shaped, and is disposed in an attitude such that its thickness direction is along the vertical direction. A lower surface of the baffle plate 6 is a facing surface that faces the first main surface Wa of the substrate W. The baffle plate 6 is, for example, circular in a plan view. A diameter of the baffle plate 6 (i.e., a diameter of the facing surface) may be, for example, 80% of a diameter of the substrate W or more, 90% of the diameter of the substrate W or more, or more than or equal to the diameter of the substrate W.

In the example of FIG. 14, the hollow shaft 61 is disposed on an upper surface of the baffle plate 6. The hollow shaft 61 includes a hollow portion. A through hole penetrating the baffle plate 6 itself in the vertical direction is formed at the center of the baffle plate 6. The hollow portion is connected to the through hole of the baffle plate 6 in the vertical direction. A nozzle 30i is disposed in the hollow portion of the hollow shaft 61 and the through hole of the baffle plate 6. A diameter of an outer circumferential surface of the nozzle 30i is smaller than a diameter of an inner circumferential surface of each of the hollow shaft 61 and the baffle plate 6. The space between the outer circumferential surface of the nozzle 30i and the inner circumferential surfaces of the hollow shaft 61 and the baffle plate 6 functions as the gas passage 30g.

In the example of FIG. 14, the nozzle 30i is connected to a downstream end of a supply pipe 31i, and an upstream end of the supply pipe 31i is connected to a downstream end of the supply pipe 31ia and a downstream end of the supply pipe 31ib. When the supply valve 32ia is opened in this structure, the first drying liquid is dispensed from the nozzle 30i. Furthermore, when the supply valve 32ib is opened, the second drying liquid is dispensed from the nozzle 30i. In other words, the nozzle 30i is shared by the first drying liquid and the second drying liquid.

In the example of FIG. 14, the nozzle 30c and the nozzle 30w are disposed outside the facing part 60. In the example of FIG. 14, a movement driver 35c and a movement driver 35w are disposed as movement drivers 35. The movement driver 35c moves the nozzle 30c between the processing position and the waiting position, and the movement driver 35w moves the nozzle 30w between the processing position and the waiting position.

In the example of FIG. 14, a movement driver 35i is disposed as a movement driver 35. The movement driver 35i moves the nozzle 30i and the facing part 60 in unison. The movement driver 35i moves the nozzle 30i and the facing part 60 in unison, for example, along the vertical direction. Here, the movement driver 35i can be a lifting driver. The movement driver 35i includes a driving source such as a motor, and a power transmitter that transmits a driving force of the driving source to the nozzle 30i and the baffle plate 6. The power transmitter includes, for example, a cam mechanism or a ball screw mechanism.

The operations of the processing unit 1 according to Embodiment 5 are also indicated by the flowchart in FIG. 4. The movement driver 35i lowers the nozzle 30i and the facing part 60 to the processing position closer to the substrate W in the first drying liquid supplying step, the second drying liquid supplying step, and the drying step, and lifts the nozzle 30i and the facing part 60 to the waiting position higher than the processing position except in these.

The first drying liquid supplying step (Step S5) and the second drying liquid supplying step (Step S6) in each of Embodiments 1 to 3 are executed also in Embodiment 5. This can reduce the pattern collapse ratio.

While the substrate processing apparatus 100 and a method of processing a substrate are described in detail above, the description is in all aspects illustrative and does not restrict this disclosure. The aforementioned various modifications are applicable in combination unless any contradiction occurs. Therefore, numerous modifications and variations that have not yet been exemplified are devised without departing from the scope of the present disclosure.

While nozzles dedicated to the respective fluids are provided in the examples of Embodiments 1 to 4, one nozzle may be shared by the fluids of different types, similarly to the nozzle 30i according to Embodiment 5. A nozzle dedicated to each of the first drying liquid and the second drying liquid may be provided in Embodiment 5. Alternatively, one nozzle may be shared by the fluids of the different types.

The substrate heating part 4 supplies a heating medium to the second main surface Wb of the substrate W in the aforementioned examples, which is not always limited to this. The substrate heating part 4 may include, for example, a heater disposed at a position facing the second main surface Wb of the substrate W in the vertical direction. The heater may be, for example, an electric resistance heater with an electric heating wire, or an optical heater that outputs light for heating.

### EXPLANATION OF REFERENCE SIGNS

bp1 first boiling point
bp2 second boiling point
S1, S11, S21 holding step (step)
S4, S16, S23 liquid supplying step (step)
S5, S17, S24 first drying liquid supplying step (step)
S6, S18, S25 second drying liquid supplying step (step)
S7, S19, S26 drying step (step)
T drying liquid supply time (second drying liquid supply time)
T1 former period
T2 latter period
W substrate
Wa first main surface
Wb second main surface

## Claims

1. A method of processing a substrate, the method comprising:
a holding step of holding a substrate having a first main surface on which a pattern is formed, and a second main surface opposite to the first main surface;
a liquid supplying step of supplying a processing liquid to the first main surface of the substrate;
a first drying liquid supplying step of supplying, after the liquid supplying step, a first drying liquid to the first main surface of the substrate, the first drying liquid having a first boiling point and having a surface tension lower than a surface tension of the processing liquid;
a second drying liquid supplying step of supplying, after the first drying liquid supplying step, a second drying liquid to the first main surface of the substrate, the second drying liquid having a second boiling point different from the first boiling point, and having a surface tension lower than the surface tension of the first drying liquid; and
a drying step of drying the substrate after the second drying liquid supplying step,
wherein the second main surface of the substrate is heated to a first temperature in at least a part of a time in the first drying liquid supplying step,
at least a part of the second main surface of the substrate is heated to a second temperature different from the first temperature, in at least a part of a time in the second drying liquid supplying step, and
a positive or negative sign of a value obtained by subtracting the second temperature from the first temperature is identical to a positive or negative sign of a value obtained by subtracting the second boiling point from the first boiling point.

2. The method according to claim 1,
wherein a heating medium of a first medium temperature is supplied to the second main surface of the substrate in the first drying liquid supplying step,
the heating medium of a second medium temperature is supplied to the second main surface of the substrate in the second drying liquid supplying step, and
a positive or negative sign of a value obtained by subtracting the second medium temperature from the first medium temperature is identical to a positive or negative sign of a value obtained by subtracting the second boiling point from the first boiling point.

3. The method according to claim 1 or 2,
wherein a higher one of the first temperature and the second temperature is higher than or equal to a lower one of the first boiling point and the second boiling point.

4. The method according to claim 1 or 2,
wherein miscibility between the processing liquid and the first drying liquid is higher than miscibility between the processing liquid and the second drying liquid.

5. The method according to claim 1 or 2,
wherein in the first drying liquid supplying step, the first drying liquid is supplied to the first main surface of the substrate at a flow rate at which a temperature of the first main surface of the substrate becomes lower than the first boiling point of the first drying liquid, while the at least the part of the second main surface of the substrate is heated to the first boiling point of the first drying liquid or higher.

6. The method according to claim 1 or 2,
wherein in the second drying liquid supplying step, the second drying liquid is supplied to the first main surface of the substrate at a flow rate at which a temperature of the first main surface of the substrate becomes lower than the second boiling point of the second drying liquid, while the at least the part of the second main surface of the substrate is heated to the second boiling point of the second drying liquid or higher.

7. The method according to claim 1 or 2,
wherein the second temperature is higher than the first temperature, and
in the second drying liquid supplying step, a temperature of the second main surface of the substrate is lower than the second temperature in a former period of a second drying liquid supply time during which the second drying liquid is supplied, and the second main surface of the substrate is heated to the second temperature in a latter period of the second drying liquid supply time.
